# EUROPEAN PATENT APPLICATION

(11) **EP 4 546 315 A1**
(43) Date of publication of application: **30.04.2025**
(21) Application number: 22959265.4
(22) Date of filing: 23.09.2022
(51) Int. Cl.: G09F 9/33, G09F 9/302, H10K 59/00, H01L 27/15, H01L 21/84

(54) **DISPLAY PANEL, DISPLAY DEVICE AND TILED DISPLAY DEVICE**

(71) Applicant: Boe Technology Group Co., Ltd., Beijing 100015 (CN); BOE MLED Technology Co., Ltd., Beijing 100176 (CN)
(72) Inventor: WANG, Lili, Beijing 100176 (CN); JIANG, Hongmei, Beijing 100176 (CN); LIU, Chao, Beijing 100176 (CN); ZHAI, Ming, Beijing 100176 (CN); QI, Qi, Beijing 100176 (CN); FENG, Sha, Beijing 100176 (CN); WANG, Jing, Beijing 100176 (CN); JIA, Mingming, Beijing 100176 (CN)
(74) Representative: Hoffmann Eitle
(86) International application number: PCT/CN2022/121121
(87) International publication number: WO 2024/060263

(57) **Abstract**

A display panel, a display device and a tiled display device. The display panel comprises a substrate, a driving circuit layer, a plurality of first binding electrodes, and a plurality of connecting leads. The substrate comprises a first surface and a second surface opposite to each other, and a plurality of side surfaces. At least one side surface of the plurality of side surfaces is a selected side surface. Each connecting lead comprises a first part located on one side of the first surface, a second part located on one side of the selected side surface, and a third part located on one side of the second surface. The first parts of two adjacent connecting leads are separated by a first gap. The first gap comprises a first type of gap area. The first type of gap area comprises a first sub-gap area and a second sub-gap area, and the first sub-gap area is closer to the selected side surface than the second sub-gap area. The size of the first sub-gap area in a first direction is smaller than the size of the second sub-gap area in the first direction.

## Description

### TECHNICAL FIELD

The present disclosure relates to the field of display technologies, and in particular, to a display panel, a display device and a tiled display device.

### BACKGROUND

The micro light-emitting diode (Micro LED) and mini light-emitting diode (Mini LED) have smaller particles, i.e., smaller volumes, compared to traditional LEDs.

### SUMMARY

In an aspect, a display panel is provided, which includes: a substrate, a driving circuit layer, a plurality of first bonding electrodes, and a plurality of connecting leads. The substrate includes a first surface, a second surface, and a plurality of side surfaces connecting the first surface and the second surface, and at least one side surface of the plurality of side surfaces is a selected side surface. The first surface of the substrate includes a display area and a peripheral area located on at least one side of the display area, and the peripheral area is closer to the selected side surface than the display area. The driving circuit layer is provided in the display area. The plurality of first bonding electrodes are arranged at intervals along a first direction, and are provided in the peripheral area. The first direction is parallel to the selected side surface of the substrate and the first surface of the substrate.

The plurality of connecting leads are arranged at intervals along the first direction. Each connecting lead of the plurality of connecting leads includes a first part located on a side of the first surface of the substrate, a second part located on a side of the selected side surface of the substrate, and a third part located on a side of the second surface of the substrate. The first part of each connecting lead is electrically connected to one of the first bonding electrodes.

First parts of two adjacent connecting leads are spaced by a first gap, first gaps include first-type gap areas. A first-type gap area includes a first sub-gap area and a second sub-gap area. A first sub-gap area of each first-type gap area is closer to the selected side surface of the substrate than a second sub-gap area of the first-type gap area. A dimension of the first sub-gap area of each first-type gap area along the first direction is less than a dimension of the second sub-gap area of the first-type gap area along the first direction.

In some embodiments, a dimension of the first sub-gap area of each first-type gap area along a second direction is less than or equal to a dimension of the second sub-gap area of the first-type gap area along the second direction. The second direction is parallel to an extension direction of the first part of the connecting lead.

In some embodiments, a difference between dimensions of a first sub-gap area and a second sub-gap area of each first-type gap area along the first direction is in a range of 0 to 100 µm.

In some embodiments, first parts of any two adjacent connecting leads of the plurality of connecting leads are spaced by a first-type gap area.

In some embodiments, the first gaps further include second-type gap areas, and a dimension of a second-type gap area along the first direction is equal to the dimension of the first sub-gap area along the first direction.

In some embodiments, a first-type gap area and at least one second-type gap area are arranged alternately.

In some embodiments, in a plurality of first-type gap areas, a boundary line between a first sub-gap area and a second sub-gap area of each first-type gap area is closer to the selected side surface than a boundary of ends, proximate to the selected side surface of the substrate, of the plurality of first bonding electrodes.

In some embodiments, the plurality of first bonding electrodes are arranged side by side at intervals along the first direction. A dimension of a first bonding electrode along the first direction is less than or equal to a dimension of a first part of a connecting lead connected to the first bonding electrode along the first direction.

In some embodiments, a dimension of the first-type gap area along the first direction is less than or equal to a distance between two first bonding electrodes adjacent thereto along the first direction.

In some embodiments, the display panel further includes a plurality of second bonding electrodes. The plurality of second bonding electrodes are provided on the side of the second surface of the substrate and are arranged at intervals along the first direction. Each second bonding electrode includes a first sub-part and a second sub-part, and the first sub-part of each second bonding electrode is closer to the selected side surface of the substrate than the second sub-part. The third part of each connecting lead is electrically connected to a first sub-part of a second bonding electrode. An extension direction of the first sub-part of the second bonding electrode is the same as an extension direction of the third part of the connecting lead electrically connected thereto.

Third parts of two adjacent connecting leads are spaced by a third gap, third gaps include third-type gap areas, and each third-type gap area in a plurality of third-type gap areas includes a third sub-gap area and a fourth sub-gap area, and the third sub-gap area of each third-type gap area is closer to the selected side surface than the fourth sub-gap area of the third-type gap area. A dimension of the third sub-gap area of each third-type gap area along the first direction is less than a dimension of the fourth sub-gap area of the third-type gap area along the first direction.

In some embodiments, third parts of any two adjacent connecting leads of the plurality of connecting leads are spaced by a third-type gap area.

In some embodiments, the third gaps further include fourth-type gap areas, and a third-type gap area and at least one fourth-type gap area are arranged alternately. A dimension of a fourth-type gap area along the first direction is equal to the dimension of the third sub-gap area along the first direction.

In some embodiments, in the plurality of third-type gap areas, a boundary line between a third sub-gap area and a fourth sub-gap area of each third-type gap area is closer to the selected side surface than a boundary of ends, proximate to the selected side surface of the substrate, of the plurality of second bonding electrodes.

In some embodiments, the plurality of second bonding electrodes are arranged at intervals along the first direction. A dimension of a second bonding electrode along the first direction is less than or equal to a dimension of a third part of a connecting lead connected to the second bonding electrode along the first direction.

In some embodiments, a dimension of the third-type gap area along the first direction is less than or equal to a distance between first sub-parts of two second bonding electrodes adjacent thereto along the first direction.

In another aspect, a display device is provided, which includes the display panel according to any one of the above embodiments.

In yet another aspect, a tiled display device is provided, which includes a plurality of display devices each according to any one of the above embodiments.

In still another aspect, a manufacturing method for a display panel is provided, which includes:
providing a substrate, where the substrate includes a first surface, a second surface, and a plurality of side surfaces connecting the first surface and the second surface, and at least one side surface of the plurality of side surfaces is a selected side surface; and the first surface of the substrate includes a display area and a peripheral area located on at least one side of the display area, and the peripheral area is closer to the selected side surface of the substrate than the display area;
forming an array layer on a side of the first surface of the substrate, where forming the array layer on the side of the first surface of the substrate includes: forming a driving circuit layer in the display area;
providing a first mask on the side of the first surface of the substrate, where the first mask includes at least a first main body part, and the first main body part covers at least a portion of the driving circuit layer proximate to the selected side surface of the substrate;
forming a conductive layer, where the conductive layer includes: a first portion located on the side of the first surface of the substrate, a second portion located on a side of the selected side surface of the substrate, and a third portion located on a side of the second surface of the substrate;
patterning the conductive layer by laser etching to form a plurality of connecting leads arranged side by side at intervals, where each connecting lead of the plurality of connecting leads includes a first part located on the side of the first surface of the substrate, a second part located on the side of the selected side surface of the substrate, and a third part located on the side of the second surface of the substrate; and etching the conductive layer by the laser to form the plurality of connecting leads includes: etching at least the second portion of the conductive layer by the laser to form second parts of the plurality of connecting leads; and
removing the first mask.

**In** some embodiments, forming the array layer on the side of the first surface of the substrate further includes: forming a plurality of first bonding electrodes in the peripheral area, where the plurality of first bonding electrodes are arranged at intervals along a first direction, and each first bonding electrode extends along a second direction; and the peripheral area extends along the first direction, and the first direction intersects the second direction.

In a step of providing the first mask on the side of the first surface of the substrate, the first main body part of the first mask further covers portions of the plurality of first bonding electrodes proximate to the display area.

In some embodiments, in a step of providing the first mask on one side of the first surface of the substrate, the first mask further includes a plurality of first finger parts; first ends of the plurality of first finger parts are connected to the first main body part, and second ends of the plurality of first finger parts extend toward the selected side surface of the substrate; the plurality of first finger parts of the first mask are closer to the selected side surface of the substrate than the first main body part.

Each first finger part is located in a gap area between two adjacent first bonding electrodes.

### BRIEF DESCRIPTION OF THE DRAWINGS

In order to describe technical solutions in the present disclosure more clearly, the accompanying drawings to be used in some embodiments of the present disclosure will be introduced briefly, and it will be obvious that, the accompanying drawings to be described below are merely drawings of some embodiments of the present disclosure, and a person of ordinary skill in the art can obtain other drawings according to those drawings. In addition, the accompanying drawings in the following description may be regarded as schematic diagrams, but are not limitations on actual sizes/dimensions of products, actual processes of methods and actual timings of signals involved in the embodiments of the present disclosure.
FIG. 1A is a sectional view of a display panel in accordance with some embodiments;
FIG. 1B is a sectional view of a display panel in accordance with some other embodiments;
FIG. 1C is a planar structural diagram of a driving circuit layer in accordance with some embodiments;
FIG. 1D is a sectional structural diagram of a driving circuit layer in accordance with some embodiments;
FIG. 2 is a flow chart of a manufacturing method for a display panel in accordance with some embodiments;
FIG. 3 to FIG. 13 are diagrams showing steps of a manufacturing method for a display panel in accordance with some embodiments;
FIG. 14 is a flow chart of a manufacturing method for a display panel in accordance with some other embodiments;
FIG. 15 is a flow chart of a manufacturing method for a display panel in accordance with yet some other embodiments;
FIG. 16 to FIG. 26 are diagrams showing steps of a manufacturing method for a display panel in accordance with some other embodiments;
FIG. 27 to FIG. 35 are flow charts of a manufacturing method for a display panel in accordance with still yet some other embodiments;
FIG. 36 is a schematic diagram showing providing a first mask on a light-emitting device layer;
FIG. 37 is a schematic diagram showing providing another first mask on a light-emitting device layer;
FIG. 38 is a sectional view taken along the sectional line GG in FIG. 36;
FIG. 39 is a sectional view taken along the sectional line HH in FIG. 36;
FIG. 40 is a front structural diagram of a display panel in accordance with some embodiments;
FIG. 41 is a front structural diagram of a display panel in accordance with some other embodiments;
FIG. 42 is a back structural diagram of a display panel in accordance with some embodiments;
FIG. 43 is a back structural diagram of a display panel in accordance with some other embodiments;
FIG. 44 is a back-front structural diagram of a display panel in accordance with yet some other embodiments;
FIG. 45 is a structural diagram of a display device in accordance with some embodiments; and
FIG. 46 is a structural diagram of a tiled display device in accordance with some embodiments.

### DETAILED DESCRIPTION

The technical solutions in some embodiments of the present disclosure will be described clearly and completely in combination with the accompanying drawings, and it will be obvious that the described embodiments are merely some but not all embodiments of the present disclosure. All other embodiments obtained by a person of ordinary skill in the art based on embodiments provided by the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to." In the description of the specification, the terms such as "one embodiment," "some embodiments," "exemplary embodiments," "example," "specific example," or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the stated specific features, structures, materials, or characteristics may be included in any one or more embodiments or examples in any suitable manner.

Hereinafter, the terms "first" and "second" are used for descriptive purposes only, and are not to be construed as indicating or implying a relative importance or implicitly indicating a number of indicated technical features. Thus, features defined by "first" and "second" may explicitly or implicitly include one or more of the features. In the description of the embodiments of the present disclosure, the term "a plurality of" or "multiple" means two or more unless otherwise specified.

In the description of some embodiments, the expressions "coupled," "connected," and derivatives thereof may be used. For example, the term "connected" may be used in the description of some embodiments to indicate that two or more components are in direct physical or electrical contact with each other. As another example, the term "coupled" may be used in the description of some embodiments to indicate that two or more components are in direct physical or electrical contact. However, the term "coupled" or "communicatively coupled" may also mean that two or more components are not in direct contact with each other, but still cooperate or interact with each other. The embodiments disclosed herein are not necessarily limited to the content herein.

The phrase "at least one of A, B, and C" has the same meaning as the phrase "at least one of A, B, or C", both including the following combinations of A, B, and C: only A, only B, only C, a combination of A and B, a combination of A and C, a combination of B and C, and a combination of A, B, and C.

The phrase "A and/or B" includes the following three combinations: only A, only B, and a combination of A and B.

The use of the phrase "applicable to" or "configured to" herein means an open and inclusive expression, which does not exclude devices that are applicable to or configured to perform additional tasks or steps.

The term "about," "substantially," or "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

The term such as "parallel," "perpendicular," "equal" as used herein includes a stated condition and a condition similar to the stated condition. A range of the similar condition is within an acceptable deviation range, and the acceptable deviation range is determined by a person of ordinary skill in the art, considering measurement in question and errors associated with measurement of a particular quantity (i.e., the limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; and the term "equal" includes absolute equality and approximate equality, and an acceptable range of deviation of the approximate equality may be, for example, a difference between two equals being less than or equal to 5% of either of the two equals.

It will be understood that, when a layer or element is referred to as being on another layer or substrate, it may be that the layer or element is directly on the another layer or substrate, or it may be that intervening layer(s) exist between the layer or element and the another layer or substrate.

Exemplary embodiments are described herein with reference to sectional views and/or plan views that are idealized schematic accompanying drawings. In the accompanying drawings, thicknesses of layers and sizes of areas/regions are enlarged for clarity. Thus, variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a curved feature. Therefore, the regions shown in the accompanying drawings are schematic in nature, and their shapes are not intended to show actual shapes of the regions in a device, and are not intended to limit the scope of the exemplary embodiments.

In order to improve product reliability and reduce transportation and maintenance costs, a large-size display device can be assembled by splicing multiple small-size display devices.

In order to avoid the fragmentation of a display image caused by splicing, it is necessary to reduce a frame size of a single small-size display device to reduce the width of a splicing seam. The small-size display device includes a display panel. For example, lines located on a side of a display surface of the display panel may be connected, through connecting leads, to a circuit board (e.g., a flexible circuit board) provided on a side of a non-display surface of the display panel, so that when a plurality of small-size display devices are spliced to form a large-size display device, a distance between adjacent small-size display devices may be smaller, thereby making the display quality of the large-size display device formed by splicing the plurality of small-size display devices be improved.

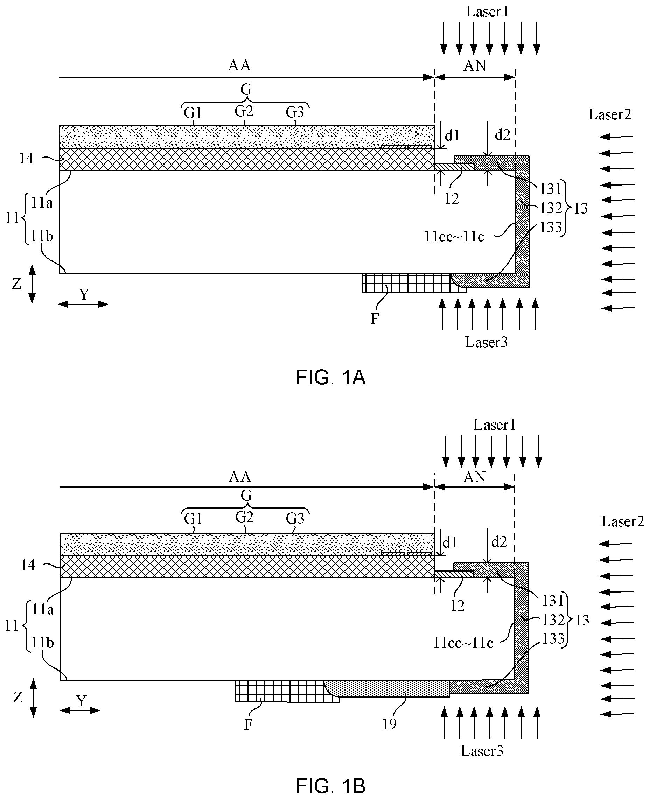

In some embodiments, as shown in FIG. 1A and FIG. 1B, the display panel includes a substrate 11, a plurality of first bonding electrodes 12, and a plurality of connecting leads 13. The substrate 11 includes a first surface 11a and a second surface 11b opposite to each other, and a plurality of side surfaces 11c connecting the first surface 11a and the second surface 11b. At least one side surface 11c of the plurality of side surfaces 11c of the substrate 11 is a selected side surface 11cc. Each connecting lead 13 includes a first part 131 located on a side of the first surface 11a of the substrate 11, a second part 132 located on a side of the selected side surface 11cc of the substrate 11, and a third part 133 located on a side of the second surface 11b of the substrate 11.

A side of the first surface 11a of the substrate 11 is provided with a light-emitting device layer G, which is a front side of the display panel; correspondingly, a side of the second surface 11b of the substrate 11 is a back side of the display panel. The first surface 11a of the substrate 11 includes a display area AA, and a film layer structure such as a driving circuit layer 14 is provided in the display area AA. The first part 131 and the third part 133 of the connecting lead 13 both extend in a direction perpendicular to the selected side surface 11cc of the substrate 11, e.g., a Y direction shown in FIG. 1A and FIG. 1B.

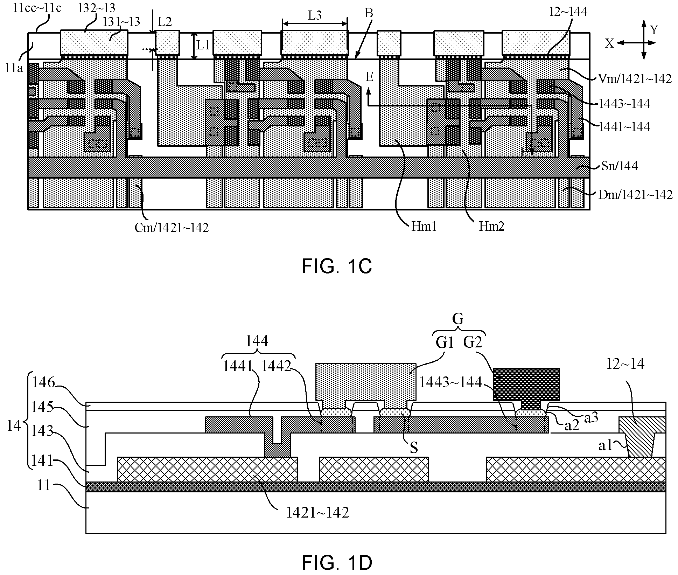

Specifically, as shown in FIG. 1C and FIG. 1D, the driving circuit layer 14 includes: a buffer layer 141, a first metal layer 142, an insulating layer 143, a second metal layer 144, a planarization layer 145, and a passivation layer 146 which are arranged in sequence from the substrate 11.

Here, the buffer layer 141 is provided on a side of the first surface 11a of the substrate 11. The first metal layer 142 is provided on a side of the buffer layer 141 away from the substrate 11. The first metal layer 142 includes a plurality of first signal lines 1421. The insulating layer 143 is provided on a side of the first metal layer 142 away from the substrate 11. The second metal layer 144 is provided on a side of the insulating layer 143 away from the substrate 11. The second metal layer 144 includes the plurality of first bonding electrodes 12 and a plurality of second signal lines 1441. The planarization layer 145 is provided on a side of the second metal layer 144 away from the substrate 11. The passivation layer 146 is provided on a side of the planarization layer 145 away from the substrate 11. It can be understood that a first bonding electrode 12 and a second signal line directly in contact with the first bonding electrode 12 are of an integral structure, and the first bonding electrode is a region located in a peripheral area and exposed by the planarization layer 145 and the passivation layer 146.

The first signal lines 1421 include a plurality of data lines Dm, a plurality of first positive signal lines Hm1, a plurality of second positive signal lines Hm2, a plurality of reference signal lines Vm and a plurality of scanning signal transfer lines Cn, which extend in the Y direction. The second metal layer 144 includes a plurality of scanning signal lines Sn, and each scanning signal line Sn is electrically connected to a scanning signal transfer line Cn. The plurality of scanning signal lines Sn extend in an X direction. For example, in a plurality of pixels arranged in an array (for example, each pixel includes three light-emitting devices G1 arranged along the Y direction, and a driving chip G2 for providing signals to the three light-emitting devices G1), each row of pixels is electrically connected to a same scanning signal line Sn, and each column of pixels is electrically connected to a data signal line Dm, a reference signal line Vm, a first positive signal line Hm1, and a second positive signal line Hm2, so as to achieve reasonable wiring for transmitting corresponding signals to the pixels through multiple signal lines.

In some embodiments, as shown in FIG. 1C and FIG. 1D, the second metal layer 144 further includes a plurality of connecting pads, and the plurality of connecting pads include a plurality of first pads 1442 for connecting light-emitting devices G1 and a plurality of second pads 1443 for connecting pixel driving chips G2.

Specifically, as shown in FIG. 1D, pins of a light-emitting device G1 and pins of a pixel driving chip G2 are connected to corresponding connecting pads through a soldering material S (such as soldering tin, tin-silver-copper alloy, tin-copper alloy, or the like). The planarization layer 145 includes a plurality of second via holes a2, and the plurality of second via holes a2 extend to the second metal layer 144. The passivation layer 146 includes a plurality of third via holes a3, and the plurality of third via holes a3 extend to the planarization layer 145. A third via hole a3 and a second via hole a2 are positioned correspondingly to form a penetrating via hole extending from the passivation layer 146 to a connecting pad of the second metal layer 144.

For example, as shown in FIG. 1C and FIG. 1D, each light-emitting device G1 includes two connecting pins, each pixel driving chip G2 includes six connecting pins. The pins of each light-emitting device G1 are connected to two first pads 1442 through penetrating via holes penetrating the planarization layer 145 and the passivation layer 146, and the pins of each pixel driving chip G2 are connected to six second pads 1443 through via holes penetrating the planarization layer 145 and the passivation layer 146, thereby controlling the light-emitting device G1 to emit light under the control of signal(s) transmitted by signal line(s) (a first signal line 1421 and/or a second signal line 1441) and the pixel driving chip G2. It can be understood that any connecting pad and a second signal line 1441 in direct contact with the connecting pad are of an integral structure, and the connecting pad is a region of the second signal line 1441 exposed by the planarization layer 145 and the passivation layer 146.

As shown in FIG. 1C and FIG. 1D, a boundary line B shown in these figures is a boundary line, proximate to the selected side surface 11cc of the substrate 11, of both the planarization layer 145 and the passivation layer 146. An orthographic projection of the boundary line B, proximate to the selected side surface 11cc of the substrate 11, of both the planarization layer 145 and the passivation layer 146 on the substrate 11 and the selected side surface 11cc of the substrate 11 have a distance L1 therebetween. The plurality of first bonding electrodes 12 are arranged side by side at intervals along the first direction X, and boundaries, proximate to the selected side surface 11cc of the substrate 11, of the plurality of first bonding electrodes 12 are flush or substantially flush. An orthographic projection of a boundary, proximate to the selected side surface 11cc of the substrate 11, of a first bonding electrode 12 on the substrate 11 and the selected side surface 11cc of the substrate 11 have a distance L2 therebetween.

Here, L1 is greater than L2, and an absolute value of a difference between L1 and L2 is in a range of 50 µm to 80 µm.

For example, the absolute value of the difference between L1 and L2 is 50µm, 70µm or 80µm.

As shown in FIG. 1C, the plurality of first bonding electrodes 12 are located in the second metal layer 144, and the plurality of first bonding electrodes 12 have different widths (dimensions along the first direction X), and a width of each first bonding electrode 12 corresponds to a width of a signal line electrically connected thereto, as shown in FIG. 1C, for example, corresponds to a width of the second signal line 1441. First bonding electrodes 12, which are electrically connected to signal lines of different widths, also have different widths.

In some embodiments, the first metal layer 142 or the second metal layer 144 is a metal layer including multiple stacked structures. For example, the first metal layer 142 or the second metal layer 144 includes a titanium layer, a copper layer, and another titanium layer, which are arranged in sequence from a side of the substrate 11. Alternatively, the first metal layer 142 or the second metal layer 144 includes, for example, a molybdenum layer, a copper layer, and another molybdenum layer, which are arranged in sequence from a side of the substrate 11. Alternatively, the first metal layer 142 or the second metal layer 144 includes, for example, a molybdenum layer, an aluminum layer, and another molybdenum layer, which are arranged in sequence from a side of the substrate 11.

In some embodiments, the first metal layer 142 or the second metal layer 144 is a signal wiring layer with a single-layer structure. Further, the driving circuit layer 14 is, for example, a copper layer or an aluminum layer.

Specifically, it is sufficient that the first metal layer 142 or the second metal layer 144 needs to have good electrical conductivity, and the exemplary description herein is not intended to be a limitation of the materials used in the driving circuit layer 14.

In some embodiments, each first bonding electrode 12 of the plurality of first bonding electrodes 12 and a corresponding signal line connected thereto in the driving circuit layer 14 (for example, the plurality of first signal lines 1421 and the plurality of second signal lines 1441) are of an integral structure, in which the first bonding electrode 12 is located in the peripheral area AN and has a surface being exposed.

Since the surface of the first bonding electrode 12 is exposed, a side of the first bonding electrode 12 away from the substrate 11 may be further provided with an antioxidation layer (a material thereof may include nickel metal, e.g., a nickel-containing alloy, or a stacked structure of a nickel layer and a gold layer), so as to prevent the film layer from being oxidized during processes and causing an unreliable electrical connection between the first bonding electrode 12 and the connecting lead 13 during a subsequent manufacturing process.

The first part 131 of each connecting lead 13 is connected to a first signal line 1421 through a first bonding electrode 12. For example, a dimension of the first bonding electrode 12 along the first direction X is adapted to a dimension of the first signal line 1421, to which the first bonding electrode 12 belongs, along the first direction X; and a dimension of the first part 131 of the connecting lead 13 along the first direction X is positively correlated with the dimension of the first bonding electrode 12, to which the first part 131 is connected, along the first direction X. As shown in FIG. 1C, the plurality of first signal lines 1421 with different functions included in the driving circuit layer 14 have different dimensions in the first direction X. It can be understood that multiple first bonding electrodes 12 corresponding to first signal lines 1421 with different functions have adaptively different dimensions along the first direction X; and correspondingly, multiple connecting leads 13 (or first parts 131 of these connecting leads 13), which are connected to first signal lines 1421 with different functions through different first bonding electrodes, have different dimensions along the first direction X.

It will be noted that in order to simplify the illustration, the dimensions of the plurality of first bonding electrodes 12 along the first direction X are shown as the same in the accompanying drawings of the specification, and it will be understood by those skilled in the art that there should be no limitation to this, and that the dimensions of the plurality of first bonding electrodes 12 along the first direction X may be different.

Correspondingly, the dimensions of the plurality of connecting leads 13 (or the first parts 131 of these connecting leads 13) along the first direction X may be the same or different.

**In** some embodiments, as shown in FIG. 1A, third parts 133 of the plurality of connecting leads 13 are configured to connect to a circuit board located on a side of the second surface 11b of the substrate 11. For example, ends, away from the selected side surface 11cc, of the third parts 133 of the plurality of connecting leads 13 serve as bonding electrodes for connecting a flexible circuit board F, which means that the third parts 133 of the plurality of connecting leads 13 need to reserve a relatively large location for bonding the external circuit.

As shown in FIG. 1B, the display panel further includes a plurality of second bonding electrodes 19. One end of each of the plurality of second bonding electrodes 19 is electrically connected to a connecting lead, and the other end is configured to connect to the circuit board located on a side of the second surface 11b of the substrate 11.

In some examples, the forming process of the plurality of connecting leads 13 is as follows that: a conductive layer connecting the first surface 11a and the second surface 11b of the substrate 11 is formed as an entire layer on the selected side surface 11cc of the substrate 11, for example, the conductive layer is formed by a stereoscopic sputtering coating process, specifically, the conductive layer includes a first portion located on a side of the first surface 11a of the substrate 11, a second portion located on a side of the selected side surface 11cc of the substrate 11, and a third portion located on a side of the second surface 11b of the substrate 11; next, the conductive layer is patterned through laser process trimming to form the plurality of independent connecting leads 13 connecting the first surface 11a and the second surface 11b of the substrate 11.

It can be understood that each connecting lead 13 includes the first part 131 located on a side of the first surface 11a of the substrate 11, the second part 132 located on the selected side surface 11cc of the substrate 11, and the third part 133 located on a side of the second surface 11b of the substrate 11.

In a direction perpendicular to the first surface 11a of the substrate 11, such as a Z direction shown in FIG. 1A and FIG. 1B, a dimension of the first part 131 of the connecting lead 13 is less than a dimension of the film layer structure in the display area AA, that is, the thickness d2 of the first part 131 of the connecting lead 13 is less than the thickness d1 of the film layer in the display area AA. As a result, in the actual laser process, during the etching process to obtain the second part 132 of the connecting lead 13, the laser may be incident from a side of the selected side surface 11cc of the substrate 11 into the display area AA of the first surface 11a, resulting in damage to the film layer on the front side of the display panel.

Please refer to FIG. 1A and FIG. 1B, when forming the second parts 132 of the plurality of connecting leads 13 by laser etching, a laser Laser2 irradiates the conductive layer in the direction shown in these figures. Since the thickness d2 of the first part 131 of the connecting lead 13 on the substrate 11 is less than the thickness d1 of the film layer in the display area AA, a part of the energy of the laser will reach the display area AA and cause damage to film layers and devices in this area, resulting in reliability problems such as localized corrosion, and failure to light a light-emitting device.

In the present application, the connecting leads 13 are formed by irradiating and etching the conductive layer by laser from three directions. In the following description, a laser Laser1 is a laser irradiating from a side of the first surface of the display panel to the display panel, and the laser Laser2 is a laser irradiating from a side of the selected side surface of the display panel to the display panel, and a laser Laser3 is a laser irradiating from a side of the second surface of the display panel to the display panel.

In some embodiments, as shown in FIG. 1A and FIG. 1B, a side of the driving circuit layer 14 away from the substrate 11 is provided with a light-emitting device layer G. The light-emitting device layer G includes a plurality of light-emitting devices G1. The driving circuit layer 14 includes signal lines. The signal lines are configured to transmit signals to the plurality of light-emitting devices G1 to drive the plurality of light-emitting devices G1 in the light-emitting device layer G to emit light.

In a case where the second part 132 of the connecting lead 13 is formed by using laser etching, after the signal lines included in the driving circuit layer 14 on the front side are irradiated by the laser, a portion of the signal lines irradiated by the laser will be removed by laser etching or be damaged, thereby affecting the normal transmission of signals. After multiple light-emitting devices G1 are irradiated by laser, the characteristics of these light-emitting devices G1 will change, so that the light-emitting effect of the light-emitting devices G1 fails to achieve the expected effect. For example, the light-emitting devices G1 fail to emit light normally or produce changes in light-emitting brightness, color, etc., thereby affecting the display effect. The above-mentioned laser damage to the film layer on the front side of the display panel includes damage to the driving circuit layer 14 and the light-emitting device layer G.

The above manufacturing processes, such as a sputtering coating process and a laser process, are only described as examples and are not intended to limit the actual production process.

In light of this, embodiments of the present disclosure provide a display panel and a manufacturing method thereof to solve the above-mentioned problem of laser damage to the film layer on the front of the display panel. In order to clearly describe the solution of the present disclosure, the manufacturing method for the display panel is first introduced.

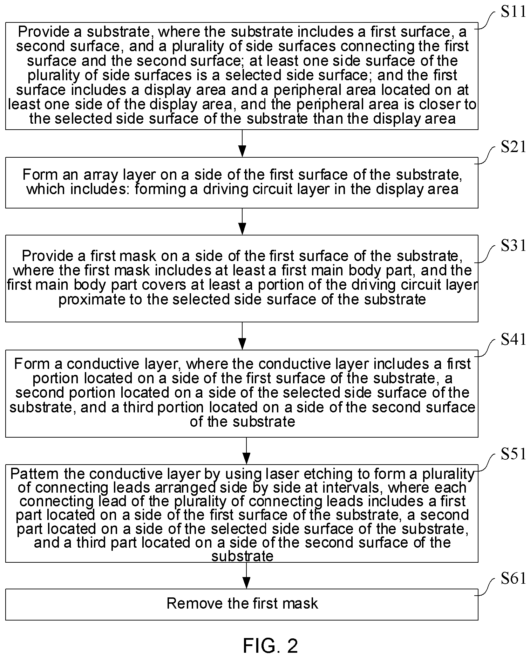

As shown in FIG. 2, a manufacturing method for the display panel includes the following steps S11 to S61.

In the step S11, a substrate 11 is provided.

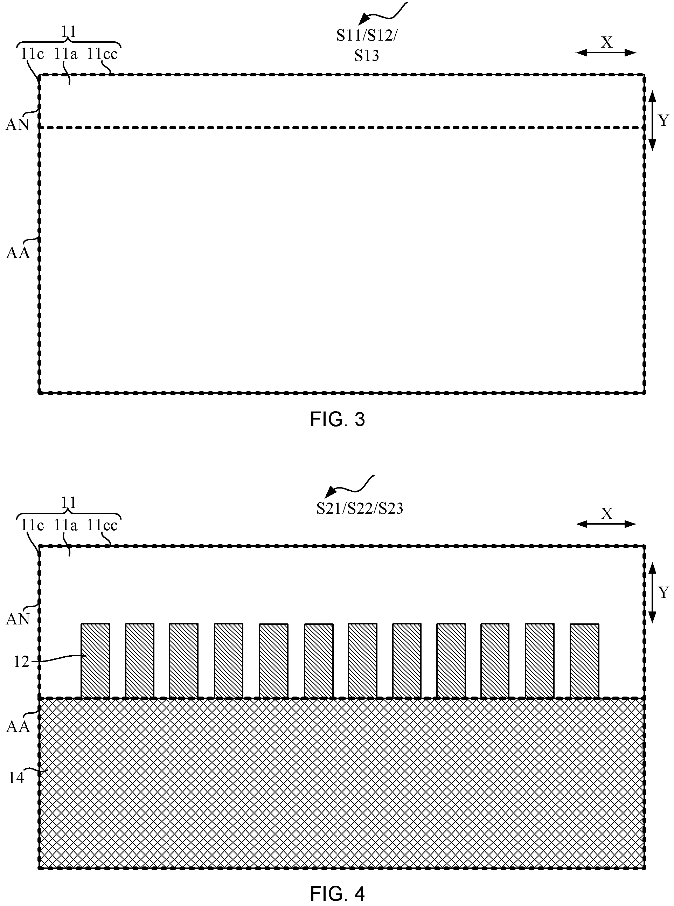

Here, as shown in FIG. 1A, FIG. 1B, and FIG. 3, the substrate 11 includes a first surface 11a, a second surface 11b, and a plurality of side surfaces 11c connecting the first surface 11a and the second surface 11b. At least one side surface 11c of the plurality of side surfaces 11c is a selected side surface 11cc. The first surface 11a includes a display area AA and a peripheral area AN located on at least one side of the display area AA. The peripheral area AN is closer to the selected side surface 11cc of the substrate 11 than the display area AA.

In some examples, a material of the substrate 11 is, for example, a rigid material, such as glass, quartz or plastic.

In some other examples, a material of the substrate 11 is, for example, a flexible material, such as a flexible printed circuit board (FPC) or a polyimide film (PI base film).

In the step S21, an array layer is formed on a side of the first surface 11a of the substrate 11.

Here, as shown in FIG. 4, forming the array layer on a side of the first surface 11a of the substrate 11 includes: forming a driving circuit layer 14 in the display area AA.

**In** the step S31, a first mask 20 is provided on a side of the first surface 11a of the substrate 11.

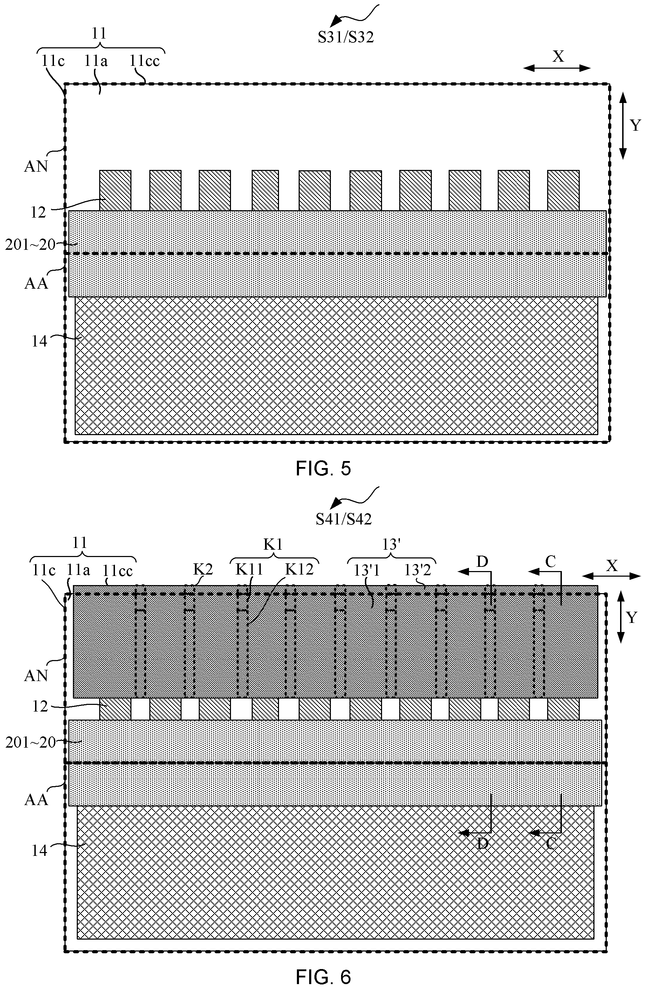

Here, as shown in FIG. 5, the first mask 20 includes at least a first main body part 201, and the first main body part 201 covers at least a portion of the driving circuit layer 14 proximate to the selected side surface 11cc of the substrate 11.

In the step S41, a conductive layer 13' is formed.

Here, as shown in FIG. 6 to FIG. 9, the conductive layer 13' includes a first portion 13'1 located on a side of the first surface 11a of the substrate 11, a second portion 13'2 located on a side of the selected side surface 11cc of the substrate 11, and a third portion 13'3 located on a side of the second surface 11b of the substrate 11.

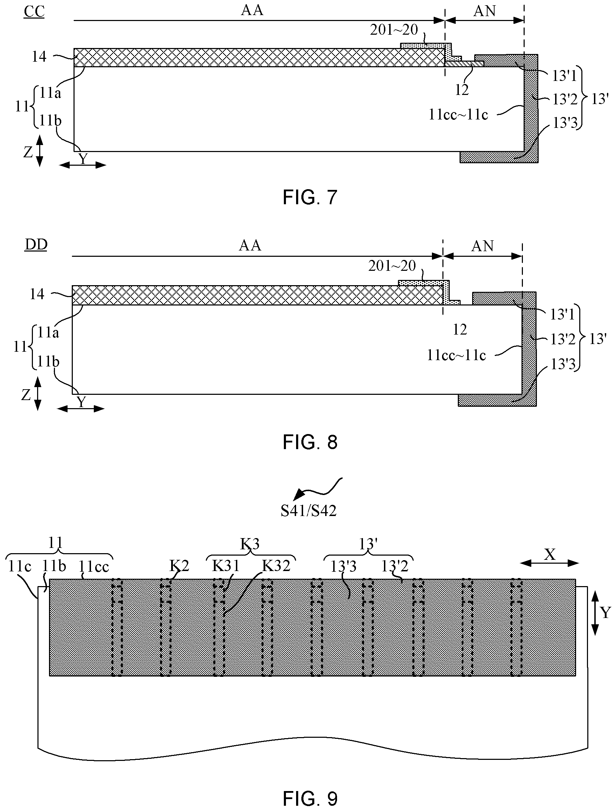

FIG. 7 and FIG. 8 are sectional views taken along sectional lines CC and DD in FIG. 6, respectively. It can be seen that the first mask 20 and the conductive layer 13' are not in contact, and there is a certain distance between the two.

In the above step, the conductive layer 13' is formed, for example, by using a stereoscopic sputtering coating process.

In the step S51, the conductive layer 13' is patterned by using laser etching to form a plurality of connecting leads 13 arranged side by side at intervals.

Here, as shown in FIG. 1A and FIG. 1B, each connecting lead 13 of the plurality of connecting leads 13 includes a first part 131 located on a side of the first surface 11a of the substrate 11, a second part 132 located on a side of the selected side surface 11cc of the substrate 11, and a third part 133 located on a side of the second surface 11b of the substrate 11.

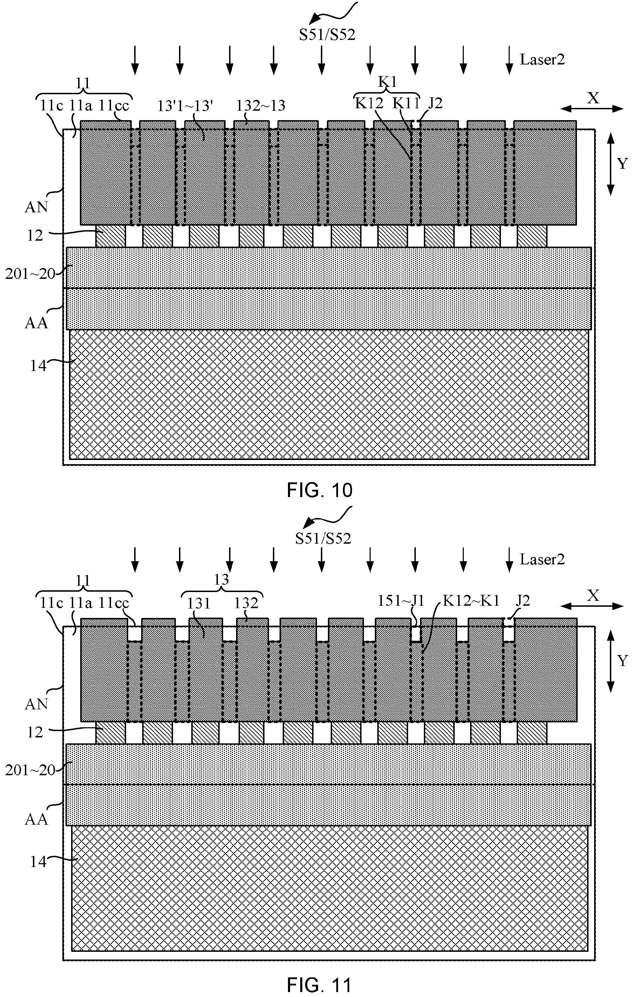

Etching the conductive layer 13' by laser to form the plurality of connecting leads 13 includes: as shown in FIG. 10 and FIG. 11, etching at least the second portion 13'2 of the conductive layer 13' by laser to form second parts 132 of the plurality of connecting leads 13.

**In** the above step, as shown in FIG. 6 to FIG. 8, the first portion 13'1 of the conductive layer 13' is non-overlapping with the first main body part 201 of the first mask 20.

In the above step, the plurality of connecting leads 13 formed through etching the conductive layer 13' by laser are independent and separated from each other, and any two connecting leads 13 of the plurality of connecting leads 13 have a gap therebetween. An area corresponding to a portion of the conductive layer 13' removed by laser etching during the laser etching process is referred to as an etching area. For example, as shown in FIG. 6, and FIG. 9 to FIG. 11, the first portion 13'1 of the conductive layer 13' includes a plurality of first etching areas K1, the second portion 13'2 of the conductive layer 13' includes a plurality of second etching areas K2, and the third portion 13'3 of the conductive layer 13' includes a plurality of third etching areas K3.

After portions corresponding to the etching areas (e.g., the plurality of first etching areas K1 and the plurality of second etching areas K2 shown in FIG. 6, and the plurality of third etching areas K3 shown in FIG. 9) are removed by etching, a spacing obtained between adjacent connecting leads 13 is a gap between the adjacent connecting leads 13.

In the step S61, the first mask 20 is removed.

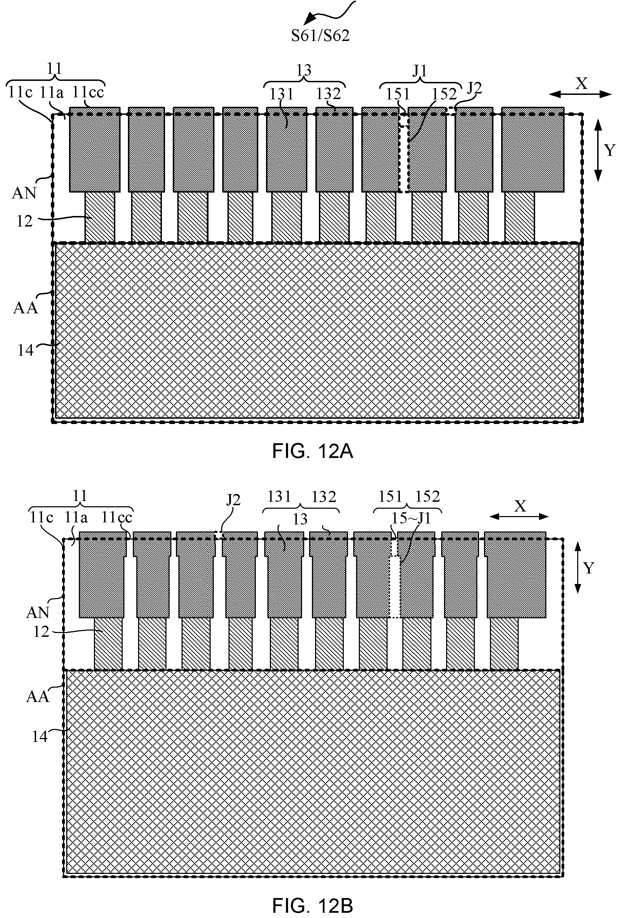

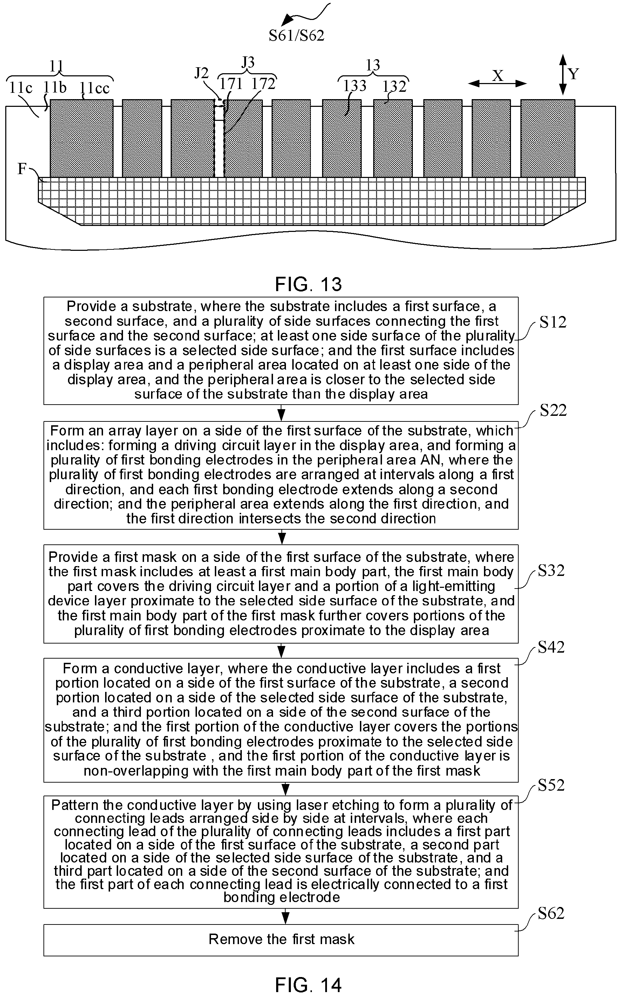

FIG. 12A, FIG. 12B and FIG. 13 are schematic diagrams showing portions, on the first surface 11a and the second surface 11b of the substrate 11, of the plurality of connecting leads 13, after the first mask 20 is removed.

In the above manufacturing method for the display panel, the driving circuit layer 14 is formed in the display area AA of the first surface 11a, and then the first mask 20 is provided on a side of the first surface 11a of the substrate 11, and the first mask 20 covers a portion of the driving circuit layer 14 proximate to the selected side surface 11cc of the substrate 11. In this way, in the process of patterning the conductive layer 13' by using laser etching, when the laser Laser2 irradiates the conductive layer 13' in the direction shown in FIG. 11, although the thickness d2 of the first part 131 of the connecting lead 13 on the substrate 11 is less than the thickness d1 of the film layer in the display area AA, since the first mask 20 covers the portion of the driving circuit layer 14 proximate to the selected side surface 11cc of the substrate 11, when the laser Laser2 irradiates the conductive layer 13' in the direction shown in FIG. 11, the laser directed to the driving circuit layer 14 will be blocked by the main body part 201 of the first mask 20, thereby protecting the driving circuit layer 14 and preventing laser damage to the driving circuit layer 14. As such, the problem that the driving circuit layer 14 is irradiated by the laser causing a portion of circuits configured for transmitting circuit signals to be removed or damaged by laser etching, thus affecting the normal transmission of the circuit signals, is avoided, and the reliability of the display panel is thereby improved.

For example, as shown in FIG. 6, each first etching area K1 of the plurality of first etching areas K1 includes a first sub-etching area K11 and a second sub-etching area K12, and the first sub-etching area K11 of each first etching area K1 is closer to the selected side surface 11cc of the substrate 11 than the second sub-etching area K12 of the first etching area K1.

As shown in FIG. 12A and FIG. 12B, a gap area formed after a portion corresponding to each first sub-etching area K11 is removed by etching is the first sub-gap area 151, and a gap area formed after a portion corresponding to each second sub-etching area K12 is removed by etching is a second sub-gap area 152. It can be understood that a first gap J1, obtained after each first etching area K1 is removed by etching, includes the first sub-gap area 151 and the second sub-gap area 152. The first sub-gap area 151 included in each first gap J1 is closer to the selected side surface 11cc of the substrate 11 than the second sub-gap area 152 included in the first gap J1.

For example, as shown in FIG. 9, each third etching area K3 of the plurality of third etching areas K3 includes a third sub-etching area K31 and a fourth sub-etching area K32, and the third sub-etching area K31 of each third etching area K3 is closer to the selected side surface 11cc of the substrate 11 than the fourth sub-etching area K32 of the third etching area K3.

As shown in FIG. 13, a gap area formed after a portion corresponding to each third sub-etching area K31 is removed by etching is a third sub-gap area 171, and a gap area formed after a portion corresponding to each fourth sub-etching area K32 is removed by etching is a fourth sub-gap area 172. It can be understood that a third gap J3, obtained after each third etching area K3 is removed by etching, includes the third sub-gap area 171 and the fourth sub-gap area 172. The third sub-gap area 171 included in each third gap J3 is closer to the selected side surface 11cc of the substrate 11 than the fourth sub-gap area 172 included in the third gap J3.

As shown in FIG. 6 and FIG. 9, the process of patterning the conductive layer 13' by using laser etching to form the complete plurality of connecting leads 13 arranged side by side at intervals, includes: removing a plurality of portions of the conductive layer 13' corresponding to the first etching areas K1 by laser etching to obtain first parts 131 of the plurality of connecting leads 13, in which first parts 131 of two adjacent connecting leads 13 are spaced by a first gap J1; removing a plurality of portions of the conductive layer 13' corresponding to the second etching areas K2 by laser etching to obtain second parts 132 of the plurality of connecting leads 13, in which second parts 132 of two adjacent connecting leads 13 are spaced by a second gap J2; and removing a plurality of portions of the conductive layer 13' corresponding to the third etching areas K3 by laser etching to obtain third parts 133 of the plurality of connecting leads 13, in which third parts 133 of two adjacent connecting leads 13 are spaced by a third gap J3.

It can be understood that the complete plurality of connecting leads 13 can be obtained after removing all of the plurality of portions of the conductive layer 13' corresponding to the first etching areas K1, the plurality of portions of the conductive layer 13' corresponding to the second etching areas K2, and the plurality of portions of the conductive layer 13' corresponding to the third etching areas K3.

For example, the laser Laser1 irradiates the conductive layer 13' to etch the plurality of first etching areas K1 of the conductive layer, thereby forming the first parts 131 of the plurality of connecting leads 13; the laser Laser2 irradiates the conductive layer 13' to etch the plurality of second etching areas K2 of the conductive layer, thereby forming the second parts 132 of the plurality of connecting leads 13; and the laser Laser3 irradiates the conductive layer 13' to etch the plurality of third etching areas K3 of the conductive layer, thereby forming the third parts 133 of the plurality of connecting leads 13.

In some examples, the plurality of portions of the conductive layer 13' corresponding the first etching areas K1, the plurality of portions of the conductive layer 13' corresponding the second etching areas K2, and the plurality of portions of the conductive layer 13' corresponding the third etching areas K3 are etched by the laser Laser1, the laser Laser2, and the laser Laser3 respectively, from different directions at the same time, so as to pattern the conductive layer 13' to obtain the plurality of connecting leads 13 as shown in FIG. 12A, FIG. 12B and FIG. 13.

It will be noted that the above is only intended as an illustrative example of a possible embodiment, and an order in which the plurality of portions of the conductive layer 13' corresponding to the first etching areas K1, the plurality of portions of the conductive layer 13' corresponding to the second etching areas K2, and the plurality of portions of the conductive layer 13' corresponding to the third etching areas K3 are etched by laser etching is not limited.

The following is a specific illustration in which the laser Laser1, the laser Laser2, and the laser Laser3 are used to etch the conductive layer 13' from different directions to form the plurality of connecting leads 13.

For example, in the step of patterning the conductive layer 13' by laser etching to form the plurality of connecting leads 13, the laser Laser2 first irradiates the conductive layer 13' to remove the portions corresponding to the plurality of second etching areas K2 of the second portion 13'2 of the conductive layer 13' by etching, thereby forming the second parts 132 of the plurality of connecting leads 13; and then, the laser Laser1 and the laser Laser3 irradiate the conductive layer 13' from different directions at different times or at the same time, so as to remove the portions corresponding to the plurality of first etching areas K1 of the first portion 13'1 of the conductive layer 13' and the portions corresponding to the plurality of third etching areas K3 of the third portion 13'3 of the conductive layer 13' by etching, thereby forming the first parts 131 and the third parts 133 of the plurality of connecting leads 13.

When etching the portions corresponding to the plurality of second etching areas K2 of the second portion 13'2 of the conductive layer 13' by laser, the laser irradiates from a side of the selected side surface 11cc of the substrate 11 toward the selected side surface 11cc of the substrate 11. After the portions corresponding to the plurality of second etching areas K2 are removed by laser etching, portions of the first portion 13'1 of the conductive layer 13' proximate to the selected side surface 11cc of the substrate 11, and/or portions of the third portion 13'3 of the conductive layer 13' proximate to the selected side surface 11cc of the substrate 11 will be removed by etching through the residual energy of the laser.

That is to say, when forming the second parts 132 of the plurality of connecting leads 13 in the step S51, as shown in FIG. 10 and FIG. 11, a plurality of portions of the conductive layer 13' corresponding to the first sub-etching areas K11 are removed by etching through the residual energy of the laser, and a plurality of portions of the conductive layer 13' corresponding to the third sub-etching areas K31 are removed by etching through the residual energy of the laser.

It can be understood that in this case, the portions of the first portion 13'1 of the conductive layer 13' that need to be removed by etching and the portions of the third portion 13'3 of the conductive layer 13' that need to be removed by etching are removed in two separate etchings. For the conductive layer 13', the portions proximate to the selected side surface 11cc of the substrate 11 (e.g., the portions corresponding to the first sub-etching areas K11 in the first etching area K1 and the portions corresponding to the third sub-etching areas K31 in the third etching area K3) are removed by etching during forming the second parts 132 of the plurality of connecting leads 13, and the remaining portions that need to be etched are removed by another etching step. Therefore, a first sub-gap area 151 and a second sub-gap area 152 included in a first gap J1 obtained after removing a portion corresponding to a first etching area K1 by etching may have the same or different dimensions along the first direction X, and a third sub-gap area 171 and a fourth sub-gap area 172 included in a second gap J2 obtained after removing a portion corresponding to a third etching area K3 by etching may have the same or different dimensions along the first direction XS.

In some embodiments, as shown in FIG. 12A, a first sub-gap area 151 and a second sub-gap area 152 included in a first gap J1 between two adjacent connecting leads 13 have the same dimension along the first direction X.

In some other embodiments, a first sub-gap area 151 and a second sub-gap area 152 included in a first gap J1 between two adjacent connecting leads 13 have different dimensions along the first direction X.

In some examples, as shown in FIG. 12B, a dimension of a first sub-gap area 151 along the first direction X included in a first gap J1 between two adjacent connecting leads 13 is less than a dimension of a second sub-gap area 152 along the first direction X included in the first gap J1.

In some other examples, a dimension of a first sub-gap area 151 along the first direction X included in a first gap J1 between two adjacent connecting leads 13 is greater than a dimension of a second sub-gap area 152 along the first direction X included in the first gap J1.

The specific structure of the first gap J1 obtained after the portion corresponding to the first etching area K1 is removed by etching and the specific structure of the third gap J3 obtained after the portion corresponding to the third etching area K3 is removed by etching, are described later, which will not be introduced in detail here.

For example, after the step S61, the manufacturing method further includes: a step S71, in which the remaining portions of the conductive layer 13' are etched by laser to form the complete plurality of connecting leads 13.

Here, etching the remaining portions of the conductive layer 13' by laser to form the complete plurality of connecting leads 13 includes: etching the first portion 13'1 of the conductive layer 13' by the laser Laser1 to form the first parts 131 of the plurality of connecting leads 13, and/or etching the third portion 13'3 of the conductive layer 13' by the laser Laser3 to form the third parts 133 of the plurality of connecting leads 13.

It will be noted that in the steps of etching the remaining portions of the conductive layer 13' by laser to form the complete plurality of connecting leads 13, the step of removing the first mask 20 is before the step of etching the first portion 13'1 of the conductive layer 13' by laser, and the steps of etching the third portion 13'3 of the conductive layer 13' by laser and removing the first mask 20 are performed in no particular order.

First parts 131 of two adjacent connecting leads 13 are spaced by a first gap J1, second parts 132 of two adjacent connecting leads 13 are spaced by a second gap J2, and third parts 133 of two adjacent connecting leads 13 are spaced by a third gap J3. Dimensions of the first gap J1, the second gap J2, and the third gap J3 each between any two adjacent connecting leads 13 will be described below.

For example, dimensions, along the first direction X, of the first gap J1, the second gap J2, and the third gap J3 may be the same or different.

In some examples, the dimensions, along the first direction X, of at least two of the first gap J1, the second gap J2, and the third gap J3 are the same. For example, the dimensions, along the first direction X, of the first gap J1 and the second gap J2 are the same, or the dimensions, along the first direction X, of the first gap J1 and the third gap J3 are the same, or the dimensions, along the first direction X, of the second gap J2 and the third gap J3 are the same, or the dimensions, along the first direction X, of the first gap J1, the second gap J2, and the third gap J3 are all same.

In some other examples, a dimension, along the first direction X, of the second gap J2 and a dimension, along the first direction X, of a first sub-gap area 151 included in the first gap J1 are the same. It can be understood that in this case, dimensions, along the first direction X, of a first sub-gap area 151 and a second sub-gap area 152 included in the first gap J1 may be the same or different.

In some yet other examples, dimensions, along the first direction X, of the second gap J2, the third gap J3, and the first sub-gap area 151 are different. For example, the dimension, along the first direction X, of the second gap J2 (or the third gap J3) is greater than the dimension, along the first direction X, of the first sub-gap area 151 included in the first gap J1.

In some other embodiments, the complete plurality of connecting leads 13 are formed during etching the conductive layer 13' by laser in the step S51, so there is no step S71 after the steps S51 and S61.

In some other embodiments, as shown in FIG. 14, some embodiments of the present disclosure provide another manufacturing method for a display panel, which includes the following steps S12 to S62.

In the step S12, a substrate 11 is provided.

Here, as shown in FIG. 1A, FIG. 1B, and FIG. 3, the substrate 11 includes a first surface 11a, a second surface 11b, and a plurality of side surfaces 11c connecting the first surface 11a and the second surface 11b. At least one side surface 11c of the plurality of side surfaces 11c is a selected side surface 11cc. The first surface 11a includes a display area AA and a peripheral area AN located on at least one side of the display area AA. The peripheral area AN is closer to the selected side surface 11cc of the substrate 11 than the display area AA.

In the step S22, an array layer is formed on a side of the first surface 11a of the substrate 11, which includes: forming a driving circuit layer 14 in the display area AA, and further includes: forming a plurality of first bonding electrodes 12 in the peripheral area AN.

Here, as shown in FIG. 4, the plurality of first bonding electrodes 12 are arranged at intervals along a first direction X, and each first bonding electrode 12 extends along a second direction Y. The peripheral area AN extends along the first direction X. The first direction X intersects the second direction Y

In the above step, the plurality of first bonding electrodes 12 are electrically connected to the driving circuit layer 14.

For example, the first direction X is perpendicular to the second direction Y.

For example, a dimension of the first bonding electrode 12 along the second direction Y is greater than or equal to 50 µm.

Further, a dimension of the first bonding electrode 12 along the second direction Y is in a range of 50 µm to 80 µm. The dimension of the first bonding electrode along the second direction Y is, for example, 50 µm, 70 µm or 80 µm.

In the step S32, a first mask 20 is provided on a side of the first surface 11a of the substrate 11.

Here, as shown in FIG. 5, the first mask 20 includes at least a first main body part 201. The first main body part 201 covers a portion of the driving circuit layer 14 proximate to the selected side surface 11cc of the substrate 11. The first main body part 201 of the first mask 20 further covers portions of the plurality of first bonding electrodes 12 proximate to the display area AA.

It will be noted that in order to better protect the driving circuit layer 14 and avoid damage to the driving circuit layer 14 when forming the connecting leads 13, the first main body part 201 included in the first mask 20 may cover the whole driving circuit layer 14. In this case, the first main body part 201 still covers the portions of the plurality of first bonding electrodes 12 proximate to the display area AA.

In the step S42, a conductive layer 13' is formed.

Here, as shown in FIG. 6 to FIG. 9, the conductive layer 13' includes a first portion 13'1 located on a side of the first surface 11a of the substrate 11, a second portion 13'2 located on a side of the selected side surface 11cc of the substrate 11, and a third portion 13'3 located on a side of the second surface 11b of the substrate 11.

The first portion 13'1 of the conductive layer 13' covers the portions of the plurality of first bonding electrodes 12 proximate to the selected side surface 11cc of the substrate 11.

In some embodiments, in the above step, the first portion 13'1 of the conductive layer 13' is non-overlapping with the first main body part 201 of the first mask 20.

It can be understood that the first portion 13'1 of the conductive layer 13' overlaps with the portions of the plurality of first bonding electrodes 12 proximate to the selected side surface 11cc of the substrate 11. Therefore, in the foregoing step of providing the first mask 20, the main body part 201 of the first mask 20 cannot cover the whole plurality of first bonding electrodes 12, but needs to expose at least the portions of the first bonding electrodes 12 overlapping with the connecting leads 13.

The first portion 13'1 of the conductive layer 13' overlaps with the portions of the plurality of first bonding electrodes 12 proximate to the selected side surface 11cc of the substrate 11, and a dimension of the overlapping portions in a direction perpendicular to the selected side surface 11cc of the substrate 11 is in a range of 30µm to 60 µm.

Along the second direction Y, the dimension of the portions, overlapping with the first portion 13'1 of the conductive layer 13', of the plurality of first bonding electrodes 12 proximate to the selected side surface 11cc of the substrate 11 is, for example, 30 µm, 50 µm, or 60 µm.

In some embodiments, a portion of a first bonding electrode 12 proximate to the display area AA is covered by the first main body part 201 of the first mask 20, and a portion of the first bonding electrode 12 away from the display area AA is covered by the first portion 13'1 of the conductive layer 13'.

For example, a dimension, along the second direction Y, of the portion of the first bonding electrode 12 covered by the first main body part 201 of the first mask 20 is in a range of 30 µm to 60 µm. The dimension, along the second direction Y, of the portion of the first bonding electrode 12 covered by the first main body part 201 of the first mask 20 is, for example, 30 µm, 45 µm, or 60 µm.

In the step S52, the conductive layer 13' is patterned by using laser etching to form a plurality of connecting leads 13 arranged side by side at intervals.

Here, as shown in FIG. 1A and FIG. 1B, each connecting lead 13 of the plurality of connecting leads 13 includes a first part 131 located on a side of the first surface 11a of the substrate 11, a second part 132 located on a side of the selected side surface 11cc of the substrate 11, and a third part 133 located on a side of the second surface 11b of the substrate 11. The first part 131 of each connecting lead 13 is electrically connected to a first bonding electrode 12.

Etching the conductive layer 13' by laser to form the plurality of connecting leads 13 includes: as shown in FIG. 10 and FIG. 11, etching at least the second portion 13'2 of the conductive layer 13' by laser to form second parts 132 of the plurality of connecting leads 13.

In the above step, several situations included in etching at least the second portion 13'2 of the conductive layer 13' by laser to form the second parts 132 of the plurality of connecting leads 13 can be referred to the foregoing description of the step S51, which will not be described again here.

In the step S62, the first mask 20 is removed, referred to as FIG. 12A, FIG. 12B and FIG. 13.

For example, after the step S62, the manufacturing method further includes the following step.

In the step S72, the remaining portions of the conductive layer 13' are etched by laser to form the complete plurality of connecting leads 13.

Here, etching the remaining portions of the conductive layer 13' by laser to form the complete plurality of connecting leads 13 includes: etching the first portion 13'1 of the conductive layer 13' by the laser to form the first parts 131 of the plurality of connecting leads 13, and/or etching the third portion 13'3 of the conductive layer 13' by the laser to form the third parts 133 of the plurality of connecting leads 13. The complete plurality of connecting leads 13 are shown in FIG. 12A, FIG. 12B and FIG. 13.

In the above step, several situations included in etching the remaining portions of the conductive layer 13' by laser to form the complete plurality of connecting leads 13 can be referred to the foregoing description of the step S71, which will not be described again here.

It will be noted that in a case where the third part 133 of the connecting lead 13 is linear and the third part 133 of the connecting lead 13 has an extension direction perpendicular to the selected side surface 11cc of the substrate 11, the third part 133 of the connecting lead 13 can be formed in the same step in which the second portion 13'2 of the conductive layer 13' is etched by laser to form the second part 132 of the connecting lead 13.

Referring to FIG. 11 and FIG. 13, a laser Laser2 irradiates the conductive layer 13' along the direction shown in FIG. 11. After a portion corresponding to a second etching area K2 of the second portion 13'2 of the conductive layer 13' is removed by laser etching, the laser can continue to irradiate the third portion 13'2 of the conductive layer 13', so as to remove a portion corresponding to a third etching area K3 of the conductive layer 13' by etching. It can be understood that in this case, the second part 132 and the third part 133 of the connecting lead 13 are formed in the same step, and second parts 132 and third parts 133 of adjacent connecting leads 13 are both formed by laser etching.

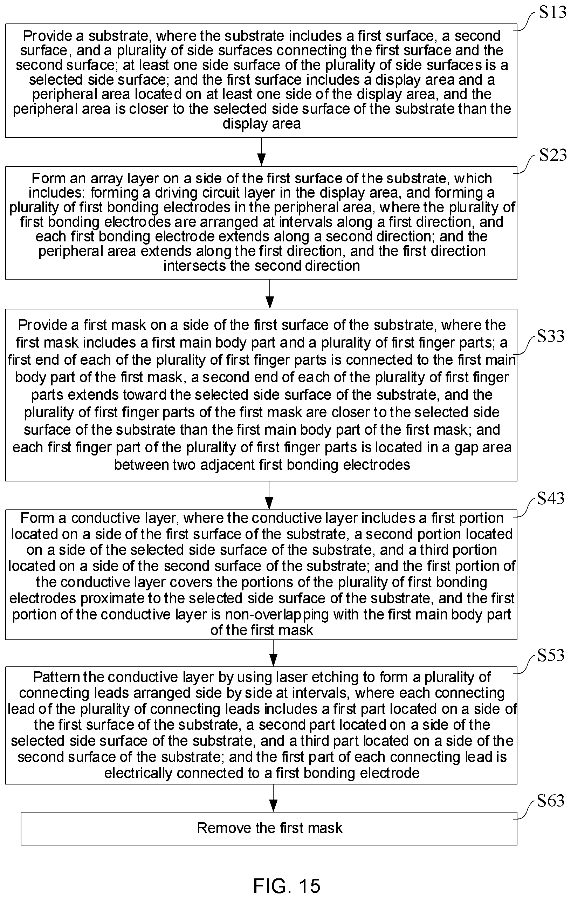

In some yet other embodiments, as shown in FIG. 15, some embodiments of the present disclosure provide yet another manufacturing method for a display panel, which includes the following steps S13 to S63.

In the step S13, a substrate 11 is provided.

Here, as shown in FIG. 1A, FIG. 1B, and FIG. 3, the substrate 11 includes a first surface 11a, a second surface 11b, and a plurality of side surfaces 11c connecting the first surface 11a and the second surface 11b. At least one side surface 11c of the plurality of side surfaces 11c is a selected side surface 11cc. The first surface 11a includes a display area AA and a peripheral area AN located on at least one side of the display area AA. The peripheral area AN is closer to the selected side surface 11cc of the substrate 11 than the display area AA.

In the step S23, an array layer is formed on a side of the first surface 11a of the substrate 11, which includes: forming a driving circuit layer 14 in the display area AA, and further includes: forming a plurality of first bonding electrodes 12 in the peripheral area AN.

Here, as shown in FIG. 4, the plurality of first bonding electrodes 12 are arranged at intervals along a first direction X, and each first bonding electrode 12 extends along a second direction Y. The peripheral area AN extends along the first direction X. The first direction X intersects the second direction Y

In the above step, the plurality of first bonding electrodes 12 are electrically connected to the driving circuit layer 14.

For example, the first direction X is perpendicular to the second direction Y.

In the step S33, a first mask 20 is provided on a side of the first surface 11a of the substrate 11.

Here, the first mask 20 includes a first main body part 201 and a plurality of first finger parts 202. A first end of each of the plurality of first finger parts 202 is connected to the first main body part 201 of the first mask 20, a second end of each of the plurality of first finger parts 202 extends toward the selected side surface 11cc of the substrate 11, and the plurality of first finger parts 202 of the first mask 20 are closer to the selected side surface 11cc of the substrate 11 than the first main body part 20 of the first mask 20.

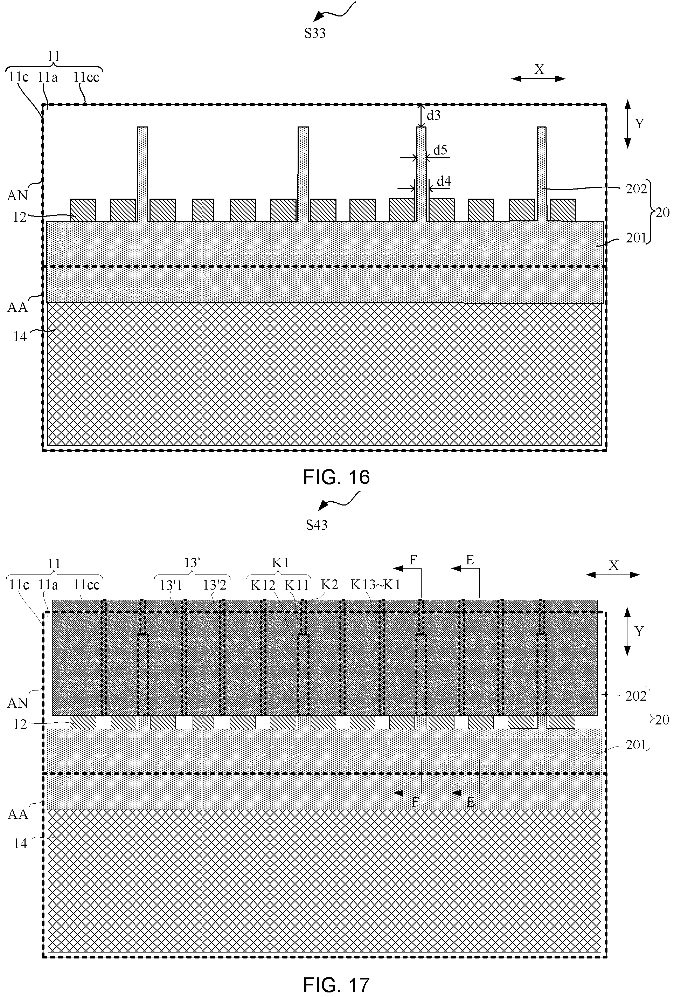

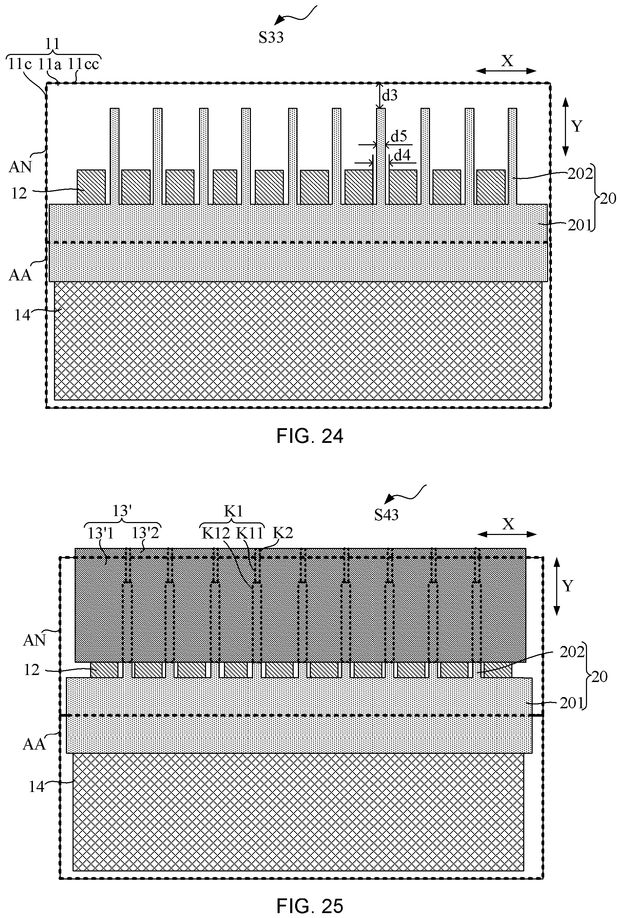

As shown in FIG. 16 and FIG. 24, there are first masks 20 having two shapes, where each first finger part 202 of the plurality of first finger parts 202 is located in a gap area between two adjacent first bonding electrodes 12.

For example, a dimension, along the second direction Y, of the first finger part 202 is greater than or equal to a dimension, along the second direction Y, of the first bonding electrode 12.

In some examples, a dimension, along the second direction Y, of the first finger part 202 is in a range of 60 µm to 1 mm.

The dimension, along the second direction Y, of the first finger part 202 is, for example, 60 µm, 500 µm, or 1 mm.

For example, in the above step, as shown in FIG. 16 and FIG. 24, there is a set distance between a boundary of orthographic projections of the plurality of first finger parts 202 of the first mask 20 on the substrate 11 and the selected side surface 11cc of the substrate 11. The set distance is, for example, a distance d3 as shown in FIG. 16 and FIG. 24.

In some embodiments, as shown in FIG. 16 and FIG. 24, the distance d3 between the boundary of the orthographic projections of the plurality of first finger parts 202 of the first mask 20 on the substrate 11 and the selected side surface 11cc of the substrate 11 is in a range of 0 to 60 µm. The distance d3 is, for example, 20 µm, 35 µm, or 60 µm.

For example, in the above step, as shown in FIG. 16 and FIG. 24, along the first direction X, a dimension d5 of each first finger part 202 of the plurality of first finger parts 202 of the first mask 20 is less than or equal to a distance d4 between two first bonding electrodes 12 adjacent thereto.

In some embodiments, the dimension, along the first direction X, of the first finger part 202 included in the first mask 20 is in a range of greater than or equal to 20 µm and less than 60 µm, and the distance, along the first direction X, between the two first bonding electrodes 12 adjacent to the above-mentioned first finger part 202 is greater than or equal to 30 µm and less than or equal to 300 µm.

In the step S43, a conductive layer 13' is formed.

Here, as shown in FIG. 17 to FIG. 19, the conductive layer 13' includes a first portion 13'1 located on a side of the first surface 11a of the substrate 11, a second portion 13'2 located on a side of the selected side surface 11cc of the substrate 11, and a third portion 13'3 located on a side of the second surface 11b of the substrate 11.

The first portion 13'1 of the conductive layer 13' covers the portions of the plurality of first bonding electrodes 12 proximate to the selected side surface 11cc of the substrate 11.

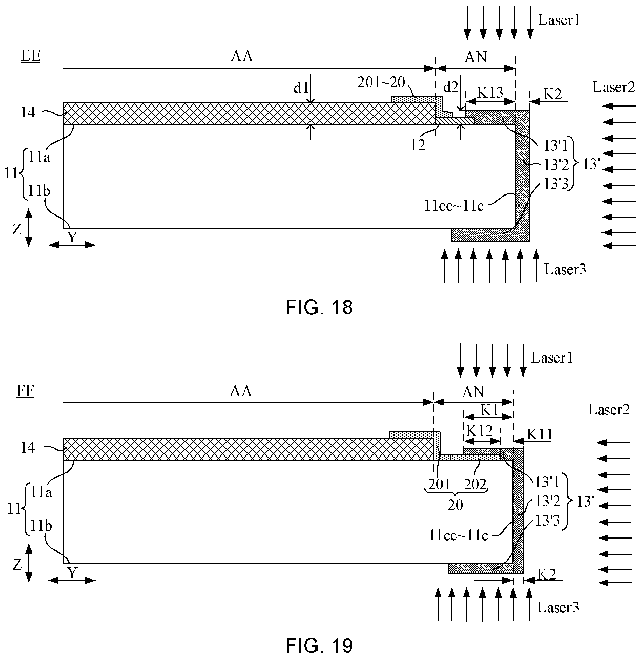

For example, in the above step, as shown in FIG. 18 and FIG. 19, where FIG. 18 is a sectional view taken along the sectional line EE in FIG. 17, and FIG. 19 is a sectional view taken along the sectional line FF in FIG. 17, the first portion 13'1 of the conductive layer 13' is non-overlapping with the first main body part 201 of the first mask 20, and the first portion 13'1 of the conductive layer 13' overlaps with the first finger part 202 of the first mask 20.

In the step S53, the conductive layer 13' is patterned by using laser etching to form a plurality of connecting leads 13 arranged side by side at intervals.

Here, as shown in FIG. 1A and FIG. 1B, each connecting lead 13 of the plurality of connecting leads 13 includes a first part 131 located on a side of the first surface 11a of the substrate 11, a second part 132 located on a side of the selected side surface 11cc of the substrate 11, and a third part 133 located on a side of the second surface 11b of the substrate 11. The first part 131 of each connecting lead 13 is electrically connected to a first bonding electrode 12.

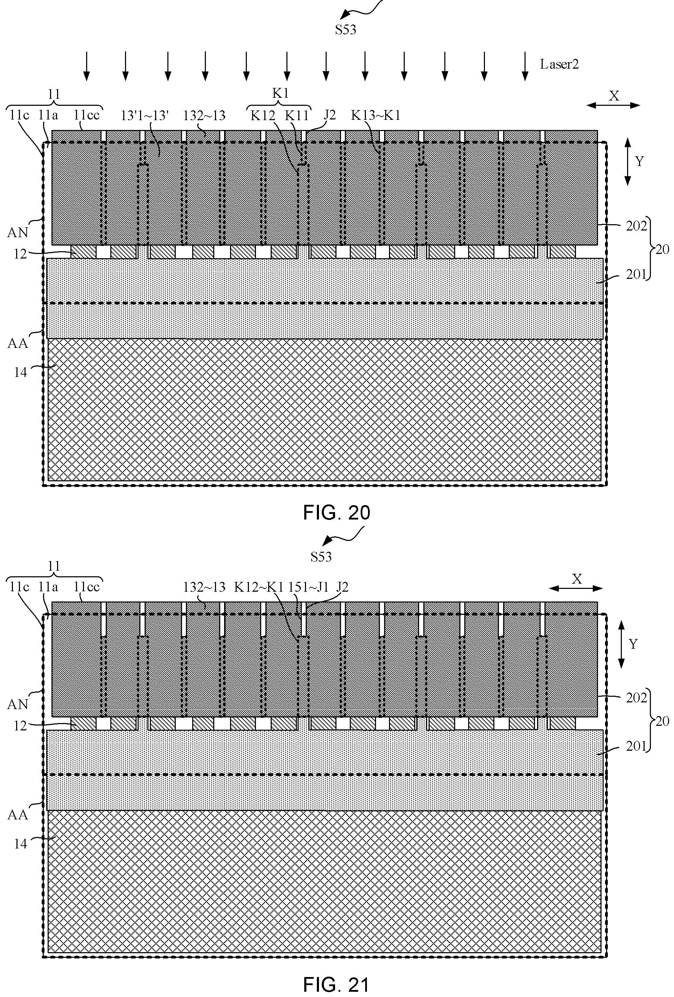

Etching the conductive layer 13' by laser to form the plurality of connecting leads 13 includes: as shown in FIG. 20 to FIG. 22, etching at least the second portion 13'2 of the conductive layer 13' by laser to form second parts 132 of the plurality of connecting leads 13.

In the above steps, for the description of the shapes of the first parts 131 and the third parts 133 of the plurality of connecting leads 13 formed through etching the conductive layer 13' by laser, and the method for forming the third parts 133 of the plurality of connecting leads 13 can be referred to the foregoing description and will not be described again here.

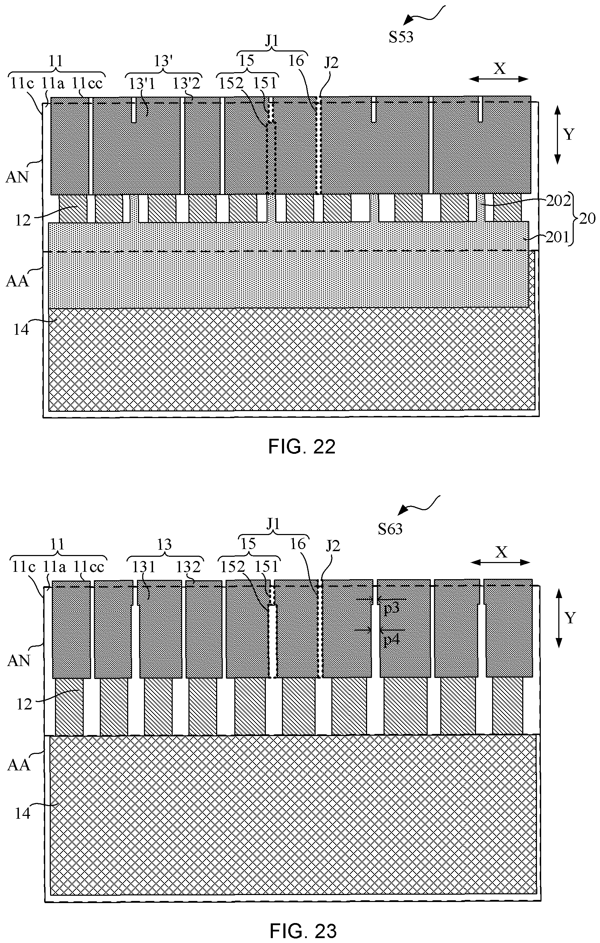

In the step S63, as shown in FIG. 23, the first mask 20 is removed.

In this step, a portion of the conductive layer located on the first finger part of the first mask is removed together with the removal of the first mask, resulting in a second sub-gap area 152 with a relatively wide as shown in FIG. 23.

In the above manufacturing method for the display panel, the driving circuit layer 14 is formed in the display area AA of the first surface 11a, and then the first mask 20 is provided on a side of the first surface 11a of the substrate 11, and the first mask 20 covers a portion of the driving circuit layer 14 proximate to the selected side surface 11cc of the substrate 11. In this way, in the process of patterning the conductive layer 13' by using laser etching, when the laser Laser2 irradiates the conductive layer 13' in the direction shown in FIG. 23, FIG. 24 and FIG. 25, although the thickness d2 of the first part 131 of the connecting lead 13 on the substrate 11 is less than the thickness d1 of the film layer in the display area AA, since the first mask 20 covers the portion of the driving circuit layer 14 proximate to the selected side surface 11cc of the substrate 11, when the laser Laser2 irradiates the conductive layer 13' in the direction shown in FIG. 23, FIG. 24 and FIG. 25, the laser directed to the driving circuit layer 14 will be blocked by the main body part 201 of the first mask 20, thereby protecting the driving circuit layer 14 and preventing laser damage to the driving circuit layer 14. As such, the problem that the driving circuit layer 14 is irradiated by the laser causing a portion of circuits configured for transmitting circuit signals to be removed or damaged by laser etching, thus affecting the normal transmission of the circuit signals, is avoided, and the reliability of the display panel is thereby improved.

It will be noted that the first portion 13'1 of the conductive layer 13' overlaps with the first finger part 202 of the first mask 20. For example, as shown in FIG. 17 and FIG. 19, portions corresponding to the second sub-etching areas K12 of the first portion 13'1 of the conductive layer 13' overlaps with the plurality of first finger parts 202 of the first mask 20, and the portions corresponding to the second sub-etching areas K12 of the first portion 13'1 of the conductive layer 13' is located on a side of the plurality of first finger parts 202 of the first mask 20 away from the substrate 11.

Therefore, when the first mask 20 is removed, portions, located on a side of the plurality of first finger parts 202 of the first mask 20 away from the substrate 11, of the first portion 13' of the conductive layer 13' are removed, which can be understood that these portions corresponding to the second sub-etching areas K12 of the first portion 13'1 of the conductive layer 13' will be removed together with the plurality of first finger parts 202 of the first mask 20 when the first mask 20 is removed.

Therefore, in the process of patterning the conductive layer 13' by laser etching to form the plurality of connecting leads 13, there is no need to etch the plurality of second sub-etching areas K12 shown in FIG. 23, which reduces the laser etching range. During the manufacturing process of the display panel, the first mask 20 not only protects the film layer structure in the display area AA, but also reduces the etching range of the conductive layer 13' for laser etching and reduces the time of laser etching steps, further improving manufacturing efficiency.

In some embodiments, as shown in FIG. 1C, FIG. 1D and FIG. 25, a dimension of the first sub-etching area K11 along the second direction Y is less than a distance L1 between an orthographic projection of the boundary line B, proximate to the selected side surface 11cc of the substrate 11, of both the planarization layer 145 and the passivation layer 146 on the substrate 11 and the selected side surface 11cc of the substrate 11.

In some examples, in the step S53, a plurality of portions of the conductive layer 13' corresponding the first etching areas K1, a plurality of portions of the conductive layer 13' corresponding the second etching areas K2, and a plurality of portions of the conductive layer 13' corresponding the third etching areas K3 are etched by the laser Laser1, the laser Laser2, and the laser Laser3 respectively, from different directions shown in FIG. 18 and FIG. 19 at the same time, so as to pattern the conductive layer 13' to obtain the plurality of connecting leads 13 as shown in FIG. 23.

For example, the display panel includes A (A ≥ 1, and A is a positive integer) first bonding electrode(s) 12 arranged at intervals along the first direction X. In this case, there are (A-1) gap areas between the A first bonding electrode(s) 12 along the first direction X, and accordingly, the number of the first finger parts 202 of the first mask 20 is less than or equal to (A-1).

It can be understood that if there is no first finger part 202 in the first mask 20, the first mask 20 includes only the first main body part 201. In this case, the setting of the first mask 20 can be referred to the foregoing description and will not be described again here.

In some embodiments, as shown in FIG. 16, along the first direction X, any two first finger parts 202 of the plurality of first finger parts 202 of the first mask 20 are provided therebetween with at least two first bonding electrodes 12.

For example, the display panel includes A (A ≥ 3, and A is a positive integer) first bonding electrodes 12. In this case, there are (A-1) gap areas between the A first bonding electrodes 12 along the first direction X; and the number of the first finger parts 202 of the first mask 20 is less than (A-1), and the first mask 20 includes at most (A-2) first finger parts 202.

For example, as shown in FIG. 1C, a distance between any two first bonding electrodes 12 of the plurality of first bonding electrodes 12 along the first direction X is not fixed.

In some embodiments, along the first direction X, a distance between any one first bonding electrode 12 of the plurality of first bonding electrodes 12 and another first bonding electrode 12 on a side of the one first bonding electrode 12 is equal to a distance between the one first bonding electrode 12 and yet another first bonding electrode 12 on the other side of the one first bonding electrode 12.

In some other embodiments, along the first direction X, a distance between any one first bonding electrode 12 of the plurality of first bonding electrodes 12 and another first bonding electrode 12 on a side of the one first bonding electrode 12 is different from a distance between the one first bonding electrode 12 and yet another first bonding electrode 12 on the other side of the one first bonding electrode 12.

In order to ensure that the first finger parts 202 included in the first mask 20 can achieve the expected effect, widths of the first finger parts 202 (dimensions thereof along the first direction X) should be within a certain range. If a width of a first finger part 202 is too small, the first finger part 202 is easily deformed, and the first finger part 202 is also easily unable to achieve the spacing effect. For example, if a width of a first finger part 202 included in the first mask 20 is greater than 20 µm, and a distance between two adjacent first bonding electrodes 12 along the first direction X is less than 20 µm, the two first bonding electrodes 12 cannot be provided therebetween with the first finger part 202.

It can be understood that compared to the case of a sufficient distance (a width of a first finger part 202 being less than a distance, along the first direction X, between two first bonding electrodes 12 adjacent thereto), if a width of a first finger part 202 disposed between two first bonding electrodes 12 is greater than a distance, along the first direction X, between these two first bonding electrodes 12 adjacent thereto, the attachment flatness of the first finger part 202 is reduced, which will cause a poor attachment of the first finger part 202, such as the inappropriate attachment and deformed shape of the first finger part 202, and it is not possible to ensure that the first finger part 202 can achieve the expected effect, causing the reliability problem of the first finger part 202.

In light of this, as shown in FIG. 16, each of the plurality of first finger parts 202 included in the first mask 20 can only be disposed between two first bonding electrodes 12 whose distance along the first direction X is greater than 20 µm. It can be understood that in this case, two first bonding electrodes 12 whose distance along the first direction X is greater than 20 µm may be or may not be provided therebetween with a first finger part 202.

In this case, in the step S53, etching at least the second portion 13'2 of the conductive layer 13' by laser to form second parts 132 of the plurality of connecting leads 13, includes the following several situations.

In some examples, the step S53 includes: a step S53a, in which the second portion 13'2 of the conductive layer 13' is etched by laser to form the second parts 132 of the plurality of connecting leads 13.

Here, a plurality of portions corresponding to the second etching areas K2 of the conductive layer 13' are removed by etching. For the obtained second parts 132 of the plurality of connecting leads 13, as shown in FIG. 20, second parts 132 of any two adjacent connecting leads 13 are spaced by a second gap J2.

In some other examples, the step S53 includes: a step S53a, in which the second portion 13'2 of the conductive layer 13' is etched by laser to form the second parts 132 of the plurality of connecting leads 13, and etching the first portion 13'1 of the conductive layer 13' by laser to form the first parts 131 of the plurality of connecting leads 13. Here, a second part 132 of each connecting lead 13 is connected to a first part 131.

Here, as shown in FIG. 21, portions, proximate to the selected side surface 11cc of the substrate 11, of the first portion 13'1 of the conductive layer 13' are removed by etching through the residual energy of the laser, during forming the second parts 132 of the plurality of connecting leads 13. It can be understood that as shown in FIG. 21, along the first direction X, a dimension of a portion of the first portion 13'1 of the conductive layer 13' removed by etching is equal to a distance between second parts 132 of two connecting leads 13 adjacent thereto.

It can be understood that in this case, an etching length of the first portion 13'1 of the conductive layer 13' by the laser incident along a direction of the Laser2 are equal to or approximately equal to a distance between a boundary of orthographic projections of the plurality of first finger parts 202 of the first mask 20 on the substrate 11 and the selected side surface 11cc of the substrate 11.

The etching length of the first portion 13'1 of the conductive layer 13' by the laser is a distance between a boundary of an orthographic projection of the remaining portion of the first portion 13'1 of the conductive layer 13' on the substrate 11 and the selected side surface 11cc of the substrate 11, after the portions of the first portion 13'1 of the conductive layer 13' proximate to the selected side surface 11cc of the substrate 11 are etched by laser. For example, a portion corresponding to a first sub-etching area K11 as shown in FIG. 17 is removed by etching to obtain a first sub-gap area 151 as shown in FIG. 23. In this case, the etching length of the first portion 13'1 of the conductive layer 13' by the laser is a distance between a boundary of an orthographic projection of the first sub-gap area 151 on the substrate 11 and the selected side surface 11cc of the substrate 11.

A portion corresponding to at least one first etching area K1 of the plurality of first etching areas K1 of the first portion 13'1 of the conductive layer 13' overlaps with the plurality of first finger parts 202 of the first mask 20. As shown in FIG. 17, the plurality of first etching areas K1 includes first-type etching areas and second-type etching areas K13, where each first-type etching area includes a first sub-etching area K11 and a second sub-etching area K12, and the first sub-etching area K11 included in each first-type etching area is closer to the selected side surface 11cc of the substrate 11 than the second sub-etching area K12 of the first-type etching area. The first sub-etching area K11, the second-type etching area K13, and the second etching area K2 have the same dimension along the first direction X.

In the above steps, after the laser Laser2 irradiates the conductive layer 13' to remove the plurality of portions of the conductive layer 13' corresponding to the second etching areas K2 by etching, as shown in FIG. 22, the laser continues to irradiate the first portion 13'1 of the conductive layer 13' to remove portions corresponding to the plurality of first sub-etching areas K11 and the plurality of second-type etching areas K13 by etching. After the portions corresponding to the plurality of first sub-etching areas K11 are removed, a plurality of first sub-gap areas 151 are obtained; and after the portions corresponding to the plurality of second-type etching areas K13 are removed, a plurality of second-type gap areas 16 are obtained.

For the plurality of first bonding electrodes 12, during the manufacturing process of the display panel, if two adjacent first bonding electrodes 12 are not spaced by a first finger part 202 of the first mask 20, in the display panel finally formed, first parts 131 of two connecting leads 13 connected to the two adjacent first bonding electrodes 12 are spaced by a second-type gap area 16, as shown in FIG. 23; and if two adjacent first bonding electrodes 12 are spaced by a first finger part 202 of the first mask 20, in the display panel finally formed, first parts 131 of two connecting leads 13 connected to the two adjacent first bonding electrodes 12 are spaced by a first-type gap area 15, as shown in FIG. 23.

It can be understood that the portions corresponding to the plurality of second sub-etching areas K12 of the conductive layer 13' will be removed together with the plurality of finger parts 202 of the first mask 20 when the first mask 20 is removed. Therefore, the laser does not need to etch these areas, which saves the time of laser etching the portions corresponding to these areas, further improving the manufacturing efficiency.

It will be noted that in the step S53, after the portions corresponding to the plurality of first sub-etching areas K11 and the plurality of second-type etching areas K13 of the first portion 13'1 of the conductive layer 13' are removed by etching, after the first mask is removed in the step S63, as shown in FIG. 23, the first parts 131 of the plurality of connecting leads 13 are formed.

In some embodiments, after the step S63, the manufacturing method further includes a step S73.

In the step S73, the remaining portions of the conductive layer 13' are etched by laser to form the complete plurality of connecting leads 13.

Here, etching the remaining portions of the conductive layer 13' by laser to form the complete plurality of connecting leads 13 includes: etching the first portion 13'1 of the conductive layer 13' by the laser to form the first parts 131 of the plurality of connecting leads 13, and/or etching the third portion 13'3 of the conductive layer 13' by the laser to form the third parts 133 of the plurality of connecting leads 13.

It can be understood that the step S73 is a supplement to the step S53, and if the portions of the conductive layer 13' corresponding to the plurality of first etching areas K1 , the plurality of second etching areas K2, and the plurality of third etching areas K3 have been completely removed by etching after the first mask 20 is removed, the step S73 does not need to be performed.

In some embodiments, only the second parts 132 of the plurality of connecting leads 13 are formed in the step S53a. In this case, the step S73a includes: etching the first portion 13'1 of the conductive layer 13' by laser to form the first parts 131 of the plurality of connecting leads 13, and etching the third portion 13'3 of the conductive layer 13' by laser to form the third parts 133 of the plurality of connecting leads 13.

It will be noted that the laser Laser1 and/or the laser Laser2 are used in the step S73.

As shown in FIG. 23, in the plurality of connecting leads 13 included in the display panel manufactured through the above processes, two adjacent connecting leads 13 are spaced by a first gap J1. The first gaps J1 include first-type gap areas 15 and second-type gap areas 16. Each first-type gap area 15 includes a first sub-gap area 151 and a second sub-gap area 152, in which the first sub-gap area 151 included in each first-type gap area 15 is closer to the selected side surface 11cc of the substrate 11 than the second sub-gap area 152 of the first-type gap area 15.

For example, a dimension of the second-type gap area 16 along the first direction X is equal to a dimension of the first sub-gap area 151 along the first direction X.

In some embodiments, a dimension of the first sub-gap area 151 included in each first-type gap area 15 along the first direction X is less than a dimension of the second sub-gap area 152 of the first-type gap area 15 along the first direction X. It can be understood that in this case, the first-type gap area 15 and the second-type gap area 16 have different shapes, in which the second-type gap area 16 is a gap of a strip shape, and the first-type gap area 15 is a gap of "Convex (the Chinese character 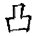 )" shape.

In some other embodiments, a dimension of the first sub-gap area 151 included in each first-type gap area 15 along the first direction X is equal to a dimension of the second sub-gap area 152 of the first-type gap area 15 along the first direction X. It can be understood that in this case, the first-type gap area 15 and the second-type gap area 16 are both gaps of a strip shape, and both have the same shape and same dimension.

As a possible design, the plurality of first bonding electrodes 12 are arranged at intervals along the first direction X, and each second bonding electrode 12 extends along the second direction Y, where the second direction Y is perpendicular to the first direction X, and the second direction Y is perpendicular to the selected side surface 11cc of the substrate 11.

In some other embodiments, as shown in FIG. 24, the first mask 20 has another shape, and any two adjacent first bonding electrodes 12 in the plurality of first bonding electrodes 12 are provided therebetween with a first finger part 202 of the first mask 20.

For example, the display panel includes A (A ≥ 2, and A is a positive integer) first bonding electrodes 12. In this case, there are (A-1) gap areas between the A first bonding electrodes 12 along the first direction X, and the number of the first finger part(s) 202 of the first mask 20 is (A-1), that is, the first mask 20 includes the (A-1) first finger part(s) 202.

In this case, in the step S43, as shown in FIG. 25, the first portion 13'1 of the conductive layer 13' includes a plurality of first etching areas K1, in which each first etching area K1 includes a first sub-etching area K11 and a second sub-etching area K12, and a portion corresponding to the second sub-etching area K12 of the first portion 13'1 of the conductive layer 13' overlaps with a first finger part 202 of the first mask 20.

In the step S53, several situations included in etching at least the second portion 13'2 of the conductive layer 13' by laser to form the second parts 132 of the plurality of connecting leads 13 can be referred to the foregoing description of the step S53.

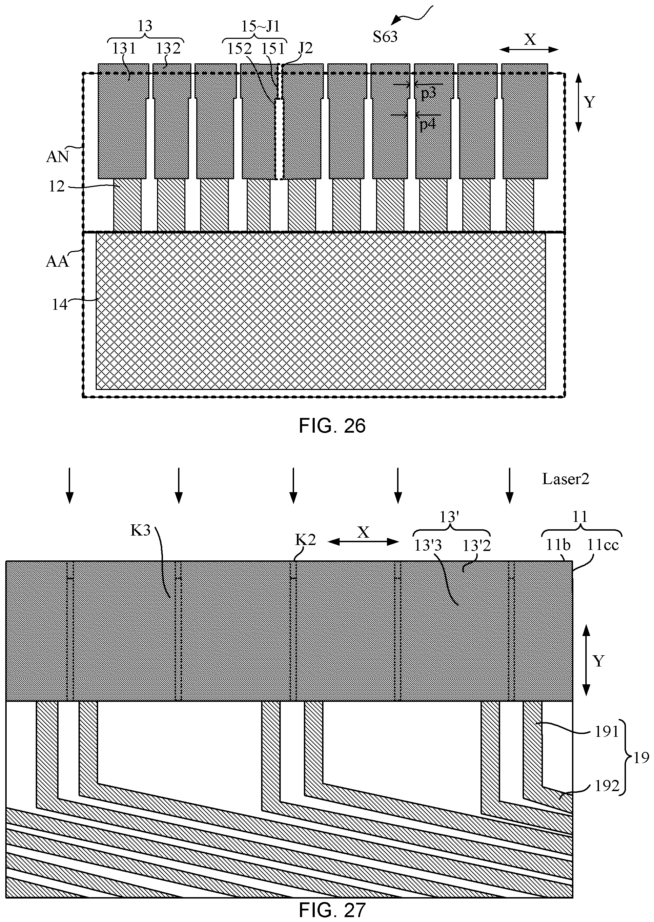

As shown in FIG. 26, in the plurality of connecting leads 13 included in the display panel manufactured through the above processes, two adjacent connecting leads 13 are spaced by a first gap J1, and the first gaps J1 are all first-type gap areas 15. Each first-type gap area 15 includes a first sub-gap area 151 and a second sub-gap area 152, in which the first sub-gap area 151 included in each first-type gap area 15 is closer to the selected side surface 11cc of the substrate 11 than a second sub-gap area 152 of the first-type gap area 15. First parts 131 of any two adjacent connecting leads 13 in the plurality of connecting leads 13 are spaced by a first-type gap area 15.

For example, the first parts 131 of any two adjacent connecting leads 13 in the plurality of connecting leads 13 are spaced by a first gap J1. A second sub-gap region 152 included in the first gap J1 is formed after a corresponding portion of the conductive layer 13' covering a first finger part 202 of the first mask 20 is removed together with this first finger part 202 when the first mask 20 is removed, and a first sub-gap area 151 included in the first gap J1 is formed through etching a corresponding portion of the conductive layer 13' by laser.

In order to ensure that a portion corresponding to the second sub-etching area K12 of the conductive layer 13' is completely removed by etching, the energy of the laser needs to meet certain conditions. In some examples, in a direction perpendicular to the first surface 11a of the substrate 11, in addition to etching the conductive layer 13', the laser further etches a surface of a film layer that is in contact with the conductive layer 13' and closer to a side of the substrate 11 (and in a case where the conductive layer is in direct contact with the substrate 11, the laser will etch a surface of the substrate 11). As a result, a dimension of the first sub-gap area 151 included in the first gap J1 in the direction perpendicular to the first surface 11a is greater than a dimension of the second sub-gap area 152 included in the first gap J1 in the direction perpendicular to the first surface 11a.

The dimensions of the first sub-gap area 151 and the second sub-gap area 152 perpendicular to the first surface 11a of the substrate 11 mentioned here refer to a depth between a surface of a side of the first sub-gap area 151/the second sub-gap area 152 away from the substrate 11 and the substrate 11 along the Z direction shown in FIG. 1A.

In some embodiments, a dimension of the first sub-gap area 151 included in each first-type gap area 15 along the first direction X is less than a dimension of the second sub-gap area 152 of the first-type gap area 15 along the first direction X. It can be understood that in this case, the first-type gap area 15 and the second-type gap area 16 have different shapes, in which the second-type gap area 16 is a gap of a strip shape, and the first-type gap area 15 is a gap of "Convex (the Chinese character 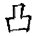 )" shape.

For example, the dimension of the first sub-gap area 151 included in the first-type gap area 15 along the first direction X is greater than or equal to 33 µm and less than or equal to 73 µm.

In some embodiments, the dimension of the first sub-gap area 151 included in the first-type gap area 15 along the first direction X is greater than or equal to 30 µm and less than or equal to 70 µm.

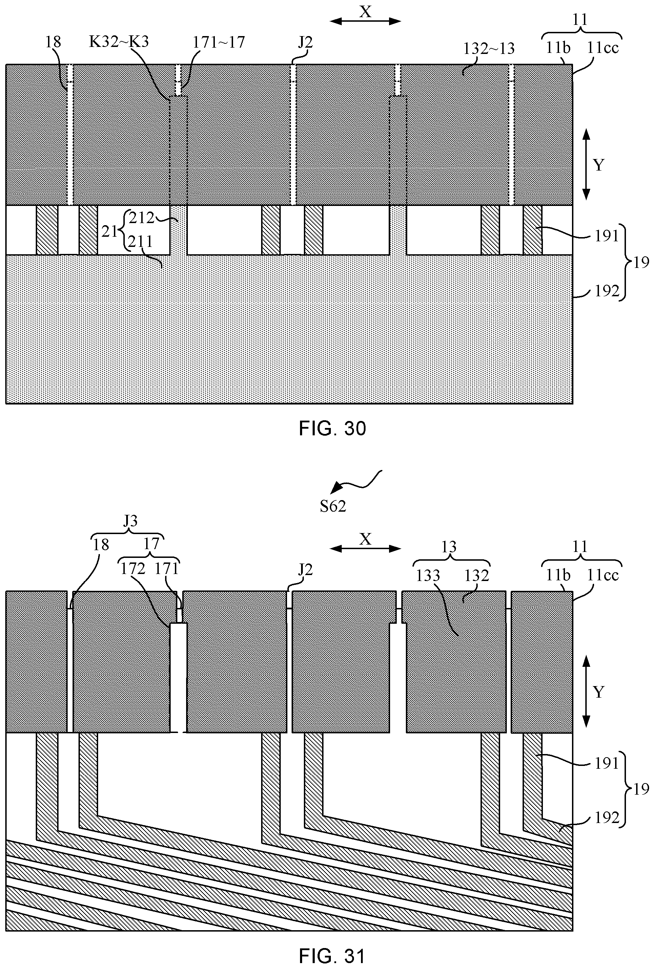

In some embodiments, as shown in FIG. 31, the display panel further includes a plurality of second bonding electrodes 19 disposed on a side of the second surface 11b of the substrate 11. Ends of the plurality of second bonding electrodes 19 proximate to the selected side surface 11cc of the substrate 11 are configured to be connected to the third parts 133 of the connecting leads 13, and ends of the plurality of second bonding electrodes 19 away from the selected side surface 11cc of the substrate 11 are configured to be connected to a circuit board located on the side of the second surface 11b of the substrate 11.

For example, portions of the ends of the plurality of second bonding electrodes 19 away from the selected side surface 11cc of the substrate 11 serve as bonding electrodes connected to the flexible circuit board F. That is to say, the plurality of second bonding electrodes 19 require a relatively large location to be reserved for external line bonding.

It can be understood that with this design, since the plurality of second bonding electrodes 19 serve as bonding electrodes connected to the flexible circuit board F, the third part 133 of the connecting lead 13 only needs to ensure effective connection with the second bonding electrodes 19, there is no need to reserve a location bonded to an external line.

Therefore, compared to using the structure as shown in FIG. 13, in which the third parts 133 of the plurality of connecting leads 13 acts as bonding electrodes and are directly electrically connected to the flexible circuit board F, in a case where the structure as shown in FIG. 31 is used, due to the presence of the second bonding electrodes 19, the length of the third part 133 of the connecting lead 13 is shortened.

The above manufacturing processes, such as a sputtering coating process and a laser process, are only described as examples and are not intended to limit the actual production process.

For the shape of the second bonding electrode 19, there are the following cases.

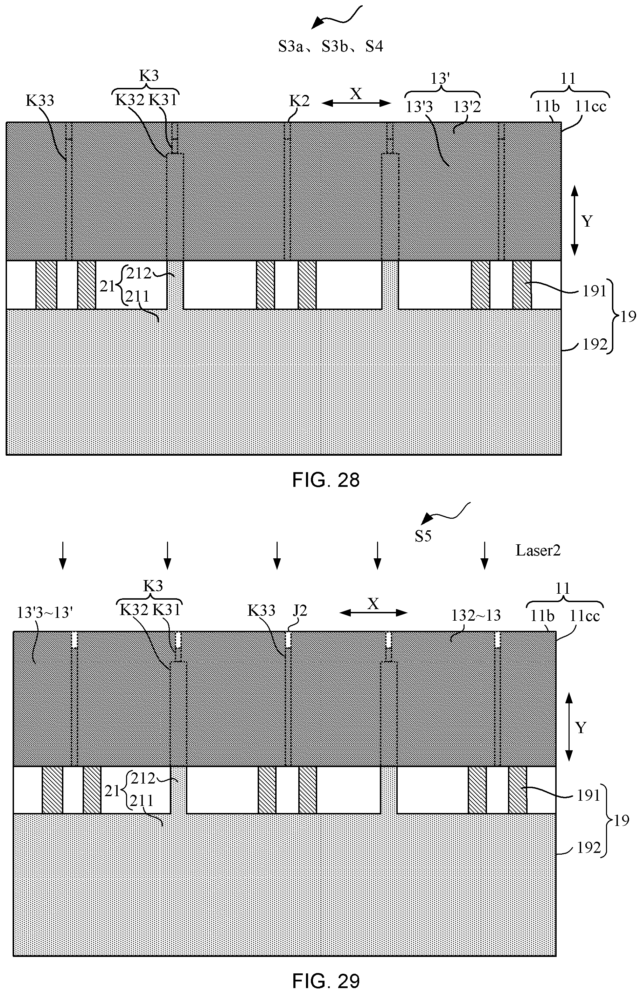

In some embodiments, the second bonding electrodes 19 are linear, and each second bonding electrode 19 extends along, for example, the Y direction shown in FIG. 28.

In some other embodiments, the second bonding electrodes 19 are non-linear, and each second bonding electrode 19 includes multiple parts with different extension directions connected end to end in sequence. For example, as shown in FIG. 27, each second bonding electrode 19 includes, for example, a first sub-part 191 and a second sub-part 192, where the first sub-part 191 and the second sub-part 192 included in the second bonding electrode 19 have different extension directions.

For example, as shown in FIG. 27, the first sub-part 191 of each second bonding electrode 19 is, for example, a straight sub-part, and the first sub-part 191 of each second bonding electrode 19 extends along the second direction Y.

It can be understood that in a case where the second bonding electrode 19 is linear and the laser Laser2 irradiates the conductive layer along the direction shown in FIG. 28 to form the second parts 132 of the plurality of connecting leads 13, a portion of the third portion of the conductive layer proximate to the selected side surface of the substrate is removed by the laser residual energy after the portions corresponding to the second etching areas of the conductive layer is etched by the laser.

The extension direction of the second bonding electrode is consistent with a direction of a laser path when the portions corresponding to the second etching areas are etched by the laser. In this way, even if the laser Laser2 irradiates the third portion of the conductive layer in the direction shown in FIG. 28, since an etching range of the laser lies between two adjacent second bonding electrodes, the laser will not be directed to the second bonding electrodes, and therefore, the second bonding electrode 19 finally formed will not be damaged.

In a case where the second bonding electrode 19 is non-linear, when the laser Laser2 irradiates the conductive layer 13' in the direction shown in FIG. 28 to form the second parts of the plurality of connecting leads, the laser residual energy will cause damage to the second bonding electrodes after the portions corresponding to the second etching areas K2 of the conductive layer 13' are etched by the laser. For example, as shown in FIG. 29, after the portions corresponding to the plurality of third etching areas K3 of the third portion 13'3 of the conductive layer 13' are removed by etching of the laser Laser2, the laser with the residual energy will irradiate the second sub-part 192 of the second bonding electrode 19, causing the second bonding electrode 19 to be damaged, resulting in defects, and thus affecting the reliability of the display panel.

It will be noted that during the process of forming the second parts of the plurality of connecting leads, an etching path of the laser lies in a range corresponding to the second etching areas K2 and the third etching areas K3, and a dimension of a third part 133 of each connecting lead 13 along the first direction X is greater than a dimension of a second bonding electrode 19 connected thereto along the first direction X, that is, the first sub-part 191 of the second bonding electrode 19 is located outside the range of the etching path of the laser, therefore, the residual energy of the laser will not cause damage to the first sub-part 191 of the second bonding electrode 19.

After the portions corresponding to the plurality of third etching areas K3 of the third portion 13'3 of the conductive layer 13' are removed by etching, the third parts 133 of the plurality of connecting leads are obtained. Therefore, an area corresponding to each third etching area K3 is an area between third parts 133 of any two adjacent connecting leads 13 in the formed plurality of connecting leads.

In order to avoid the above problem, in some embodiments, a manufacturing method for a display panel is provided, which includes the following steps.

In the step S1, a substrate 11 is provided.

Here, as shown in FIG. 1A and FIG. 1B, the substrate 11 includes a first surface 11a, a second surface 11b, and a plurality of side surfaces 11c connecting the first surface 11a and the second surface 11b. At least one side surface 11c of the plurality of side surfaces 11c is a selected side surface 11cc. The first surface 11a includes a display area AA and a peripheral area AN located on at least one side of the display area AA. The peripheral area AN is closer to the selected side surface 11cc of the substrate 11 than the display area AA.

In the step S2a, an array layer is formed on a side of the first surface 11a of the substrate 11.

Here, forming the array layer on a side of the first surface 11a of the substrate 11 includes: forming at least a driving circuit layer 14 in the display area AA.

For example, in the above step, forming the array layer on a side of the first surface 11a of the substrate 11 further includes: forming a plurality of first bonding electrodes 12 in the peripheral area AN. Here, as shown in FIG. 4, the plurality of first bonding electrodes 12 are arranged at intervals along a first direction X, and each first bonding electrode 12 extends along a second direction Y. The peripheral area AN extends along the first direction X. The first direction X intersects the second direction Y.

In the above step, the plurality of first bonding electrodes 12 are electrically connected to the driving circuit layer 14.

For example, the first direction X is perpendicular to the second direction Y.

In the step S2b, the first mask 20 is provided on a side of the first surface 11a of the substrate 11.

Here, as shown in FIG. 5, the first mask 20 includes at least a first main body part 201. The first main body part 201 covers a portion of the driving circuit layer 14 proximate to the selected side surface 11cc of the substrate 11. The first main body part 201 of the first mask 20 further covers portions of the plurality of first bonding electrodes 12 proximate to the display area AA.

For example, in the above step, as shown in FIG. 16 and FIG. 24, the first mask 20 further includes a plurality of first finger parts 202.

In the step S3a, a plurality of second bonding electrodes 19 arranged side by side at intervals are forming on a side of the second surface 11b of the substrate 11.

Here, as shown in FIG. 27, each second bonding electrode 19 includes a first sub-part 191 and a second sub-part 192. The first sub-part 191 of each second bonding electrode 19 is closer to the selected side surface 11cc of the substrate 11 than the second sub-part 192 of the second bonding electrode 19.

A third part 133 of each connecting lead 13 is electrically connected to a first sub-part 191 of a second bonding electrode 19. An extension direction of the first sub-part 191 of the second bonding electrode 19 is the same as an extension direction of an end of the third part 133 of the connecting lead 13 connected thereto.

In the step S3b, a second mask 21 is provided on a side of the second surface 11b of the substrate 11.

Here, as shown in FIG. 28, the second mask 21 includes at least a second main body part 211. The second main body part 211 covers at least portions of second sub-parts 192 of the plurality of second bonding electrodes 19 proximate to the selected side surface 11cc of the substrate 11.

In some embodiments, in the above step, the second mask 21 provided further includes a plurality of second finger parts 212. A first end of each of the plurality of second finger parts 212 is connected to the second main body part 211, a second end of each of the plurality of second finger parts 212 extends toward the selected side surface 11cc of the substrate 11, and the plurality of second finger parts 212 of the second mask 21 are closer to the selected side surface 11cc of the substrate 11 than the second main body part 211 of the second mask 21.

As shown in FIG. 28, each second finger part 212 of the plurality of second finger parts 212 of the second mask 21 is located in a gap area between two adjacent second bonding electrodes 19.

For example, in the above step, there is a set distance between a boundary of orthographic projections of the plurality of second finger parts 212 of the second mask 21 on the substrate 11 and the selected side surface 11cc of the substrate 11.

For example, in the above step, along the first direction X, a dimension of each second finger part 212 of the plurality of second finger parts 212 of the second mask 21 is less than or equal to a distance between two second bonding electrodes 19 adjacent thereto.

For example, the second bonding electrode 19 is formed by a patterning process of film formation, exposure, development and etching.

In the step S4, a conductive layer 13' is formed.

Here, the conductive layer 13' includes a first portion 13'1 located on a side of the first surface 11a of the substrate 11, a second portion 13'2 located on a side of the selected side surface 11cc of the substrate 11, and a third portion 13'3 located on a side of the second surface 11b of the substrate 11.

The first portion 13'1 of the conductive layer 13' covers portions of the plurality of first bonding electrodes 12 proximate to the selected side surface 11cc of the substrate 11. As shown in FIG. 28, the third portion 13'3 of the conductive layer 13' covers portions of the plurality of second bonding electrodes 19 proximate to the selected side surface 11cc of the substrate 11.

In some embodiments, in the above step, the first portion 13'1 of the conductive layer 13' is non-overlapping with the first main body part 201 of the first mask 20; and the third portion 13'3 of the conductive layer 13' is non-overlapping with the second main body part 211 of the second mask 21.

In the step S5, the conductive layer 13' is patterned by using laser etching to form a plurality of connecting leads 13 arranged side by side at intervals.

Here, as shown in FIG. 1A and FIG. 1B, each connecting lead 13 of the plurality of connecting leads 13 includes a first part 131 located on a side of the first surface 11a of the substrate 11, a second part 132 located on a side of the selected side surface 11cc of the substrate 11, and a third part 133 located on a side of the second surface 11b of the substrate 11. The first part 131 of each connecting lead 13 is electrically connected to a first bonding electrode 12.

Etching the conductive layer 13' by laser to form the plurality of connecting leads 13 includes: as shown in FIG. 29, FIG. 30, FIG. 33, and FIG. 34, etching at least the second portion 13'2 of the conductive layer 13' by laser to form second parts 132 of the plurality of connecting leads 13.

In the step S61, the first mask 20 is removed.

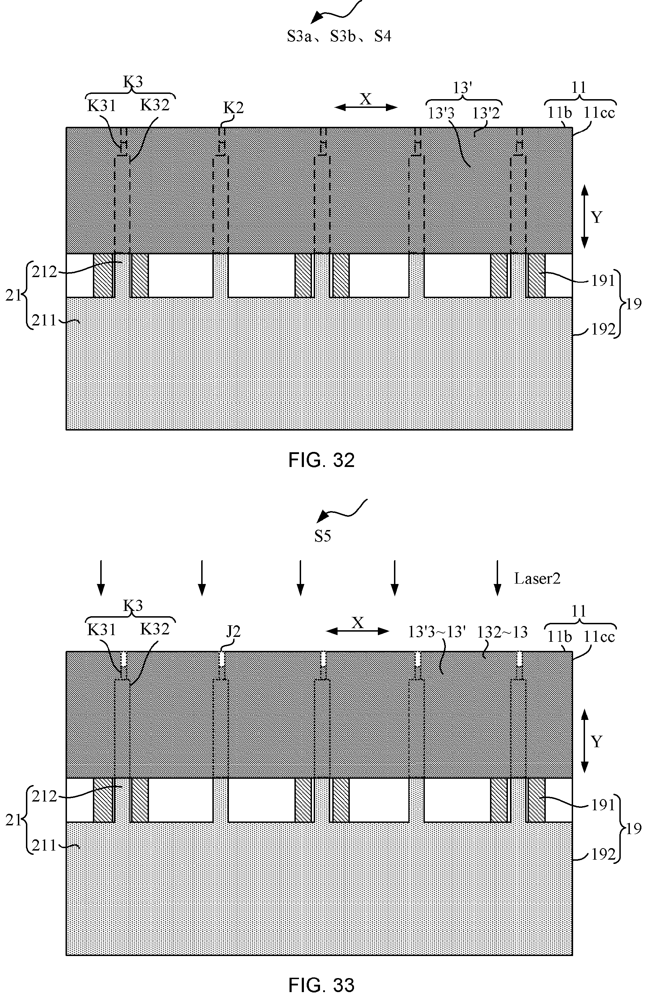

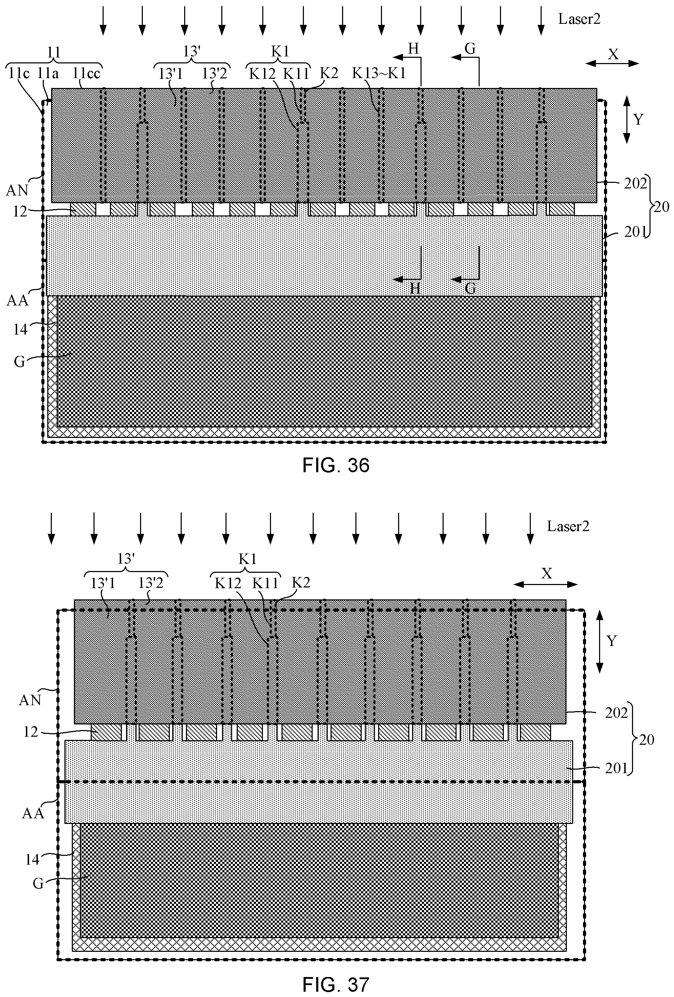

In the step S62, as shown in FIG. 32 and FIG. 36, the second mask 21 is removed. Portions of the third portion of the conductive layer located on the second mask 21 are removed together with the removal of the second mask 21 to form gaps.

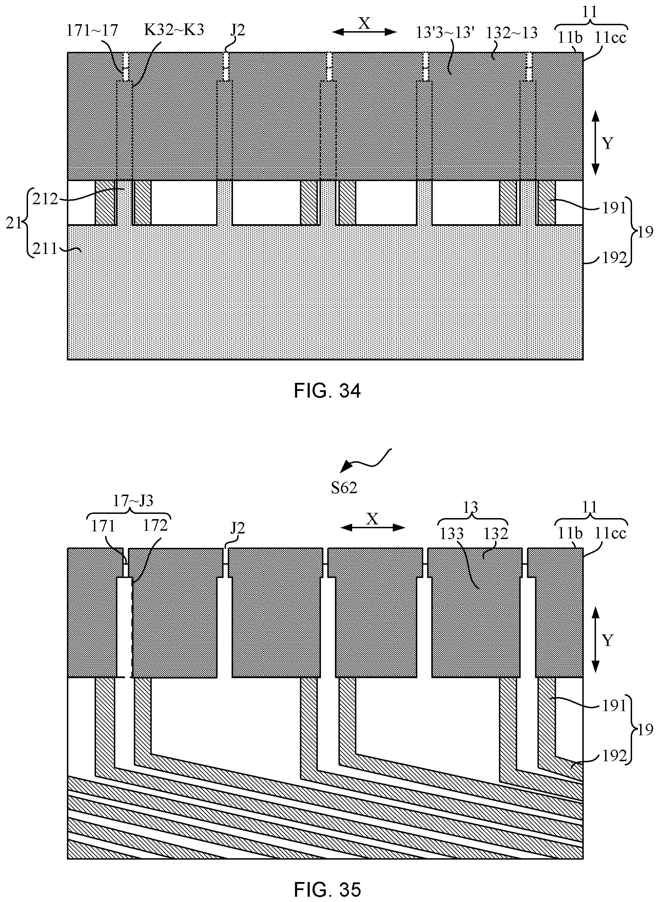

In some embodiments, as shown in FIG. 31 and FIG. 35, along the first direction X, a dimension of a third part 133 of a connecting lead 13 is greater than a dimension of a second bonding electrode 19 connected thereto.

In some other embodiments, along the first direction X, a dimension of a third part 133 of a connecting lead 13 is equal to a dimension of a second bonding electrode 19 connected thereto.

In some yet other embodiments, along the first direction X, a dimension of a third part 133 of a connecting lead 13 is less than a dimension of a second bonding electrode 19 connected thereto.

For example, in the above steps, the step of providing the first mask 20 is after the step of forming the array layer, and the step of providing the second mask 21 is after the step of forming the plurality of second bonding electrodes 19.

For example, in the above steps, the order of the step of forming the array layer and the step of forming the plurality of second bonding electrodes is not limited.

For example, in the above steps, the step of removing the first mask is after forming the second parts of the plurality of connecting leads and before forming the first parts of the plurality of connecting leads.

For example, in the above steps, the step of removing the second mask is after forming the second parts of the plurality of connecting leads and before forming the third parts of the plurality of connecting leads.

In the step S5, the method for forming the first parts and the second parts of the plurality of connecting leads is as described above and will not be described again here.

The following introduces a method for forming the third parts 133 of the plurality of connecting leads 13 in a case where the display panel includes the plurality of second bonding electrodes 19.

In some embodiments, in the step of providing the second mask, the second mask includes a second main body part. The second main body part covers at least portions of the second sub-parts of the plurality of second bonding electrodes proximate to the selected side surface of the substrate.

In this case, the laser Laser2 etches the second portion of the conductive layer to form the second parts of the plurality of connecting leads. Since the portions of the second sub-parts of the plurality of second bonding electrodes proximate to the selected side surface of the substrate are covered by the second main body part of the second mask, after portions corresponding to the third etching areas K3 are removed by etching of the laser, the laser is blocked by the second main body part of the second mask, thereby avoiding the problem that the second sub-part 192 of the second bonding electrode 19 is damaged by the residual energy of the laser.

Next, the second mask 21 is removed. Then, the portions corresponding to the plurality of third etching areas of the third portion of the conductive layer are removed by etching of the laser Laser3 along the direction shown in FIG. 1B, thereby forming third parts of the complete plurality of connecting leads.

For specific method steps, please refer to the method described above for forming the first parts of the plurality of connecting leads in a case where the first mask includes only the first main body part.

In some other embodiments, in the step of providing the second mask 21, as shown in FIG. 28 and FIG. 32, the second mask 21 includes a second main body part 211 and a plurality of second finger parts 212. The second main body part 201 covers at least portions of the second sub-parts 192 of the plurality of second bonding electrodes 19 proximate to the selected side surface 11cc of the substrate 11.

For example, the display panel includes B (B ≥ 1, and B is a positive integer) second bonding electrode(s) 19 arranged at intervals along the first direction X. In this case, there are (B-1) gap areas between the B second bonding electrode(s) 19 along the first direction X, and accordingly, the number of the second finger parts 212 of the second mask 21 is less than or equal to (B-1).

It can be understood that if there is no second finger part 212 in the second mask 21, the second mask 21 includes only the second main body part 211.

In some embodiments, the number of the plurality of second finger parts 212 of the second mask 21 is relatively small, as shown in FIG. 28, along the first direction X, any two second finger parts 212 of the plurality of second finger parts 212 of the second mask 21 are provided therebetween with at least two second bonding electrodes 19.

For example, the display panel includes B (B ≥ 3, and B is a positive integer) second bonding electrodes 19. In this case, there are (B-1) gap areas between the B second bonding electrodes 19 along the first direction X; and the number of the second finger parts 212 of the second mask 21 is less than (B-1), and the second mask 21 includes at most (B-2) second finger parts 212.

It will be noted that a portion corresponding to at least one third etching area K3 of the plurality of third etching areas K3 of the third portion 13'3 of the conductive layer 13' overlaps with the plurality of second finger parts 212 of the second mask 21. As shown in FIG. 28, the plurality of third etching areas K3 include third-type etching areas and fourth-type etching areas K33, where each third-type etching area includes a third sub-etching area K31 and a fourth sub-etching area K32, and the third sub-etching area K31 included in the third-type etching area is closer to the selected side surface 11cc of the substrate 11 than the fourth sub-etching area K32 of the third-type etching area. The third sub-etching area K31, the fourth-type etching area K33, and the second etching area K2 have the same dimension along the first direction X.

In a case where the second mask 21 is removed, portions, located on a side of the plurality of second finger parts 212 of the second mask 21 away from the substrate 11, of the third portion 13'3 of the conductive layer 13' are portions corresponding to the fourth sub-etching areas K32. It can be understood that the portions corresponding to the fourth sub-etching areas K32 of the third portion 13'3 of the conductive layer 13' will be removed together with the removal of the plurality of second finger parts 212 of the second mask 21 when the second mask 21 is removed.

In this case, in the step S5, etching at least the second portion 13'2 of the conductive layer 13' by laser to form second parts 132 of the plurality of connecting leads 13, includes the following several situations.

In some embodiments, as shown in FIG. 29 and FIG. 33, the step S5 includes: a step S5a, in which the second part 13'2 of the conductive layer 13' is etched by laser to form the second parts 132 of the plurality of connecting leads 13.

In the above step, as shown in FIG. 29 and FIG. 30, the laser Laser2 etches portions corresponding to the plurality of second etching areas K2 of the second portion 13'2 of the conductive layer 13' along the direction shown in FIG. 32 to form the second parts 132 of a plurality of connecting leads 13.

**In** the above process, after the laser removes the portions corresponding to the plurality of second etching areas K2 by etching, the residual energy of the laser will cause damage to portions of the third portion 13'3 of the conductive layer 13' proximate to the selected side surface 11cc of the substrate 11. For example, after the second parts 132 of the plurality of connecting leads 13 are formed, the residual energy of the laser removes the portions corresponding to the plurality of third sub-etching areas K31 in the third portion 13'3 of the conductive layer 13'.

**In** this case, after the step of removing the first mask, the manufacturing method further includes a step S71a, in which the first portion 13'1 of the conductive layer 13' is etched by laser to form the first parts 131 of the plurality of connecting leads 13.

**In** this case, after the step of removing the second mask, as shown in FIG. 30, the manufacturing method further includes: a step S72a, in which the third portion 13'3 of the conductive layer 13' is etched by laser to form the third parts 133 of a plurality of connecting leads 13.

**It** can be understood that in the above steps, the order of the step S71 and the step S72 is not limited.

**In** some other embodiments, the step S5 includes: a step S5b, in which the second portion 13'2 of the conductive layer 13' is etched by laser to form the second parts 132 of the plurality of connecting leads 13, and the first portion 13'1 of the conductive layer 13' is etched by laser to form the first parts 131 of the plurality of connecting leads 13.

In the above step, the method for forming the first parts and the second parts of the plurality of connecting leads is as described above and will not be described again here.

In this case, after the step of removing the first mask, the first parts 131 of the complete plurality of connecting leads 13 are formed.

In this case, after the step of removing the second mask, the manufacturing method further includes: a step S72b, in which the third portion 13'3 of the conductive layer 13' is etched by laser to form the third parts 133 of the plurality of connecting leads 13.

In some yet other embodiments, the step S5 includes: a step S5c, in which the second portion 13'2 of the conductive layer 13' is etched by laser to form the second parts 132 of the plurality of connecting leads 13, and the third portion 13'3 of the conductive layer 13' is etched by laser to form the third parts 133 of the plurality of connecting leads 13.

Since the portions corresponding to the plurality of fourth sub-etching areas K32 of the third portion 13'3 of the conductive layer 13' will be removed together with the plurality of second finger parts 212 of the second mask 21 when the second mask 21 is removed, in the above step, when the laser etches the third portion 13'3 of the conductive layer 13', as shown in FIG. 33, only the portions corresponding to the plurality of third sub-etching areas K31 and the plurality of fourth-type etching areas K33 of the third portion 13'3 of the conductive layer 13' are needed to be removed by etching.

It can be understood that in this case, the time of etching the portions corresponding to the plurality of fourth sub-etching areas K32 by laser is saved, and the manufacturing efficiency is further improved.

In this case, after the step of removing the first mask, the manufacturing method further includes: a step S71c, in which the first portion 13'1 of the conductive layer 13' is etched by laser to form the first parts 131 of the plurality of connecting leads 13.

In this case, after the step of removing the second mask, as shown in FIG. 31 and FIG. 35, the third parts 133 of the complete plurality of connecting leads 13 are formed.

In some still other embodiments, the step S5 includes: a step S5d, in which the second portion 13'2 of the conductive layer 13' is etched by laser to form the second parts 132 of the plurality of connecting leads 13, and the first portion 13'1 of the conductive layer 13' is etched by laser to form the first parts 131 of the plurality of connecting leads 13, and the third portion 13'3 of the conductive layer 13' is etched by laser to form the third parts 133 of the plurality of connecting leads 13.

In some other embodiments, the number of the plurality of second finger parts 212 of the second mask 21 is relatively large, as shown in FIG. 32, a gap area between any two adjacent second bonding electrodes 19 of the plurality of second bonding electrodes 19 is provided therein with a second finger part 212 of the second mask 21.

For example, the display panel includes B (B ≥ 2, and B is a positive integer) second bonding electrodes 19. **In** this case, there are (B-1) gap areas between the B second bonding electrodes 19 along the first direction X, and the number of the second finger part(s) 212 of the second mask 21 is (B-1), that is, the second mask 21 includes the (B-1) second finger part(s) 212.

In this case, in the step S5, as shown in FIG. 32, a portion corresponding to the fourth sub-etching area K32 included in the third etching area K3 of the third portion 13'3 of the conductive layer 13' overlaps with a second finger part 212 of the second mask 21.

In this case, in the process of forming the second parts 132 of the plurality of connecting leads 13, the laser Laser2 etches the second portion 13'2 of the conductive layer 13'.

In some embodiments, as shown in FIG. 33, the laser only removes a plurality of portions of the conductive layer 13' corresponding to the second etching areas K2 by etching.

In some other embodiments, as shown in FIG. 34, after the laser removes a plurality of portions of the conductive layer 13' corresponding to the second etching areas K2 by etching, the residual energy of the laser will cause damage to portions of the third portion 13'3 of the conductive layer 13' proximate to the selected side surface 11cc of the substrate 11.

For example, as shown in FIG. 32 and FIG. 34, when forming the second parts 132 of the plurality of connecting leads 13, after the laser removes the plurality of portions of the conductive layer 13' corresponding to the second etching areas K2 by etching, the laser will further remove the portions corresponding to the plurality of third sub-etching areas K31 of the third portion 13'3 of the conductive layer 13' by etching. **In** this case, after the second mask 21 is removed, the third parts 133 of the plurality of connecting leads 13 are formed as shown in FIG. 35.

It can be understood that the laser is directed to the second portion and the third portion of the conductive layer from one direction, which reduces the manufacturing process as compared to etching the second portion and the third portion of the conductive layer with the laser directed to the conductive layer in two directions, as shown in FIG. 1B.

In some embodiments, before the step of providing the first mask 20, as shown in FIG. 36 and FIG. 37, the manufacturing method further includes: forming a light-emitting device layer G on a side of the driving circuit layer 14 away from the substrate 11.

As shown in FIG. 36 to FIG. 39, the first mask 20 includes at least a first main body part 201, or the first mask 20 includes a first main body part and a plurality of first finger parts. The first main body part 201 covers at least a portion of the driving circuit layer 14 proximate to the selected side surface 11cc of the substrate 11. The main body part 201 of the first mask 20 further covers a portion of the light-emitting device layer G proximate to the selected side surface 11cc of the substrate 11.

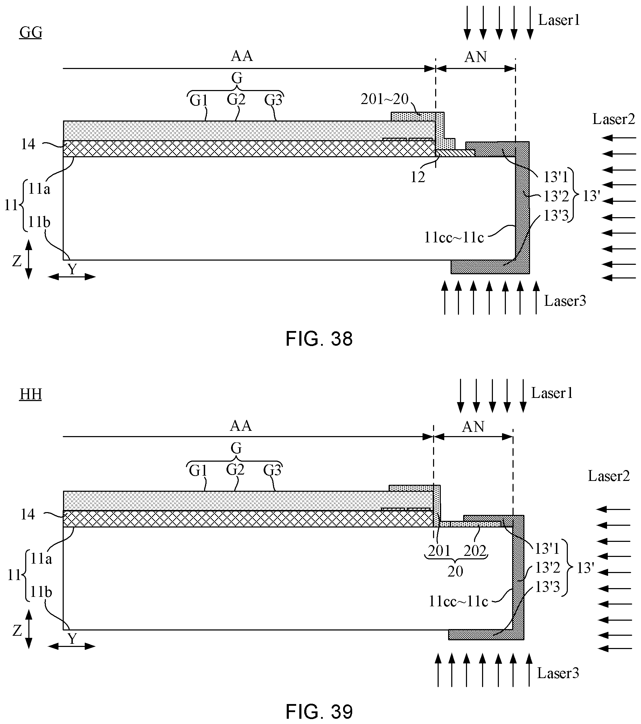

FIG. 38 and FIG. 39 are sectional views taken along sectional lines GG and HH in FIG. 36, respectively. During the process of laser etching to form the plurality of connecting leads, the laser is blocked by the first mask 20. Own to the protective effect of the first mask 20, the laser will not cause damage to the light-emitting device layer, improving the quality of the display panel.

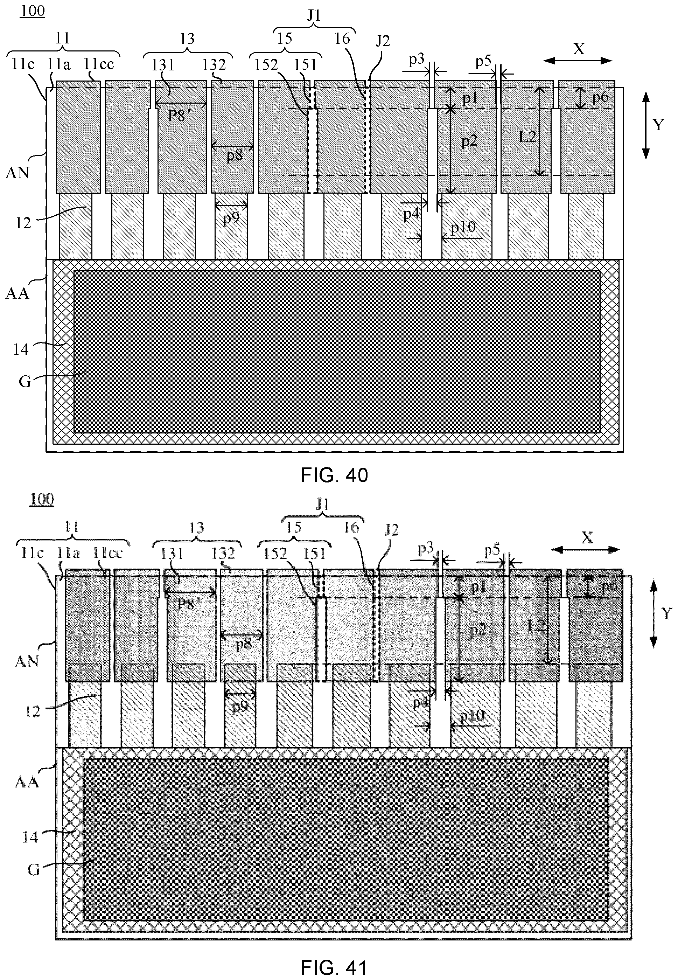

In some other embodiments, after forming the complete plurality of connecting leads, as shown in FIG. 40 and FIG. 41, the manufacturing method further includes: forming a light-emitting device layer G on a side of the driving circuit layer 14 away from the substrate 11.

It can be understood that the step of forming the light-emitting device layer G may be before the step of forming the complete plurality of connecting leads 13 or after the step of forming the complete plurality of connecting leads 13.

For example, as shown in FIG. 1C and FIG. 40, a dimension p1 of the first sub-gap area 151 along the second direction Y is less than a distance L2 between an orthographic projection of a boundary of the first bonding electrode 12 proximate to the selected side surface 11cc of the substrate 11 on the substrate 11 and the selected side surface 11cc of the substrate 11.

In another aspect, embodiments of the present disclosure provide a display panel 100, as shown in FIG. 1A, FIG. 1B, FIG. 40, and FIG. 41, which includes: a substrate 11, a driving circuit layer 14, a plurality of first bonding electrodes 12, a plurality of connecting leads 13. The substrate 11 includes a first surface 11a, a second surface 11b, and a plurality of side surfaces 11c connecting the first surface 11a and the second surface 11b. At least one side surface 11c of the plurality of side surfaces 11c is a selected side surface 11cc.

The first surface 11a of the substrate 11 includes a display area AA and a peripheral area AN located on at least one side of the display area AA. The peripheral area AN is closer to the selected side surface 11cc of the substrate 11 than the display area AA. The driving circuit layer 14 is provided in the display area AA. The plurality of first bonding electrodes 12 are provided in the peripheral area AN and arranged at intervals along a first direction X. The first direction X is parallel to the selected side surface 11cc of the substrate 11 and the first surface 11a of the substrate 11.

The plurality of connecting leads 13 are arranged at intervals along the first direction X. Each connecting lead 13 of the plurality of connecting leads 13 includes a first part 131 located on a side of the first surface 11a of the substrate 11, a second part 132 located on a side of the selected side surface 11cc of the substrate 11, and a third part 133 located on a side of the second surface 11b of the substrate 11. The first part 131 of each connecting lead 13 is electrically connected to a first bonding electrode 12.

First parts 131 of two adjacent connecting leads 13 are spaced by a first gap J1, and the first gaps J1 include first-type gap areas 15. Each first-type gap area 15 includes a first sub-gap area 151 and a second sub-gap area 152. The first sub-gap area 151 of each first-type gap area 15 is closer to the selected side surface 11cc of the substrate 11 than the second sub-gap area 152 of the first-type gap area 15. As shown in FIG. 23 and FIG. 26, a dimension p3 of the first sub-gap area 151 of each first-type gap area 15 along the first direction X is less than a dimension p4 of the second sub-gap area 152 of the first-type gap area 15 along the first direction X.

The first parts 131 of two adjacent connecting leads 13 in the plurality of connecting leads 13 in the display panel provided by the above embodiments of the present application are spaced by a first gap J1, and the first gaps J1 include the first-type gap areas 15. Each first-type gap area 15 includes a first sub-gap area 151 and a second sub-gap area 152. The dimension p3 of the first sub-gap area 151 of each first-type gap area 15 along the first direction X is less than the dimension p4 of the second sub-gap area 152 of the first-type gap area 15 along the first direction X. Referring to the foregoing introduction to the manufacturing method for the display panel, the plurality of connecting leads 13 have above structural features, this is because during the manufacturing process, before forming the conductive layer and performing laser etching, a first mask 20 is provided on the driving circuit layer 14, covering the portion of the driving circuit layer 14 proximate to the selected side surface 11cc of the substrate 11, in this way, when the laser Laser2 irradiates the conductive layer 13' along the direction perpendicular to a side of the selected side surface 11cc of the substrate 11, the laser directed to the driving circuit layer 14 will be blocked by the main body part 201 of the first mask 20, thereby protecting the driving circuit layer 14 and preventing laser damage to the driving circuit layer 14. As such, the problem that the driving circuit layer 14 is irradiated by the laser causing a portion of circuits configured for transmitting circuit signals to be removed or damaged by laser etching, thus affecting the normal transmission of the circuit signals, is avoided, and the reliability of the display panel is thereby improved.

Moreover, since the first mask 20 includes the first main body part 201 and the plurality of first finger parts 202, portions of the conductive layer formed on the plurality of first finger parts 202 can be removed together with the removal of the first mask 20, so that the second sub-gap area 152 of the first-type gap area 15 can be formed without etching these portions of the conductive layer by laser, and the dimension of the second sub-gap area 152 is equal to or substantially equal to the dimension of the first finger part 202, thereby saving laser etching steps, reducing laser etching range, and improving manufacturing efficiency.

It will be noted that during the manufacturing process of the display panel, the first mask 20, which includes only the first main body part 201, can protect the driving circuit layer 14. In some possible cases, the dimension p3 of the first sub-gap area 151 of the first-type gap area 15 along the first direction X is greater than or equal to the dimension p4 of the second sub-gap area 152 of the first-type gap area 15 along the first direction X. During the manufacturing process of the display panel, the first mask 20 includes the first main body part 201, after the second parts 132 of the plurality of connecting leads 13 are formed by laser etching, the laser with the residual energy will continue to irradiate the substrate 11 along a direction of the laser Laser2 to remove portions of first parts 131 of two adjacent connecting leads 13 proximate to the selected side surface 11cc of the substrate 11 by etching. In this case, the first sub-gap area 151 is etched by the laser Laser2 from a side of the selected side surface of the display panel, and the second sub-gap area 152 is etched by the laser Laser1 from a side of the first surface of the display panel, in which etching widths caused by the lasers in the two directions may be consistent or inconsistent, and accordingly, the dimensions of the first sub-gap area 151 and the second sub-gap area 152 of the first-type gap area 15 in the first direction are consistent or inconsistent.

It will be noted that the first sub-gap area 151 included in the first-type gap area 15 can also be etched by the laser Laser1 from a side of the first surface of the display panel. In this case, the first sub-gap area 151 and the second sub-gap area 152 included in the first-type gap area 15 are both etched by the laser Laser1 from the side of the first surface of the display panel.

During the manufacturing process of the display panel, when the laser is scanning back and forth, the etching path of the laser is greater than the etching area, and the etching range of the laser will exceed the length that needs to be etched, which is to ensure that portions corresponding to the etching areas (the first etching areas K1, the second etching areas K2 or the third etching areas K3) are completely removed by etching (that is, the portions that need to be removed by etching will not have any residue after the etching process is completed), and there will be no residue in the portions of the conductive layer that should have been removed by etching, resulting in at least two connecting leads of the plurality of connecting leads that should not have electrical connection relationship with each other are electrically connected together, which causes abnormal signal transmission.

For example, as shown in FIG. 37 and FIG. 41, in a case where the dimension of the first sub-etching area K11 of the first etching area K1 along the first direction X is, for example, 0.5 mm, the scanning path of the laser along the first direction X exceeds the dimension of the first sub-etching area K11 of the first etching area K1 along the first direction X by 10 µm to 13 µm when etching the first sub-etching area K11.

It can be understood that although the first gap J1 is formed by removing the first etching area K1, an orthographic projection of a portion corresponding to the first gap J1 on the substrate 11 surrounds an orthographic projection of a portion corresponding to the first etching area K1 on the substrate 11. For example, an absolute value of a difference between a dimension of the first gap J1 along the first direction X and a dimension of the first etching area K1 along the first direction X is in a range of 10 µm to 13 µm, and an absolute value of a difference between a dimension of the first gap J1 along the second direction Y and a dimension of the first etching area K1 along the second direction Y is in a range of 10 µm to 13 µm.

Correspondingly, an orthographic projection of a portion corresponding to the second gap J2 on the substrate 11 surrounds an orthographic projection of a portion corresponding to the second etching area K2 on the substrate 11. For example, an absolute value of a difference between a dimension of the second gap J2 along the first direction X and a dimension of the second etching area K2 along the first direction X is in a range of 10 µm to 13 µm, and an absolute value of a difference between a dimension of the second gap J2 along the second direction Y and a dimension of the second etching area K2 along the second direction Y is in a range of 10 µm to 13 µm.

An orthographic projection of a portion corresponding to the third gap J3 on the substrate 11 surrounds an orthographic projection of a portion corresponding to the third etching area K3 on the substrate 11. For example, an absolute value of a difference between a dimension of the third gap J3 along the first direction X and a dimension of the third etching area K3 along the first direction X is in a range of 10 µm to 13 µm, and an absolute value of a difference between a dimension of the third gap J3 along the second direction Y and a dimension of the third etching area K3 along the second direction Y is in a range of 10 µm to 13 µm.

In some embodiments, as shown in FIG. 40 and FIG. 41, a dimension p1 of a first sub-gap area 151 of each first-type gap area 15 along the second direction Y is less than or equal to a dimension p2 of a second sub-gap area 152 of the first-type gap area 15 along the second direction Y. The second direction Y is parallel to an extension direction of the first part 131 of the connecting lead 13.

For example, the dimension p1 of the first sub-gap area 151 of each first-type gap area 15 along the second direction Y is greater than or equal to 33 µm and less than or equal to 73 µm.

In some examples, the dimension p1 of the first sub-gap area 151 of each first-type gap area 15 along the second direction Y is greater than or equal to 30 µm and less than or equal to 70 µm.

During the manufacturing process of the plurality of connecting leads 13, when the second parts 132 of the plurality of connecting leads 13 are formed through laser etching, the laser with the residual energy will further etch portions of the first parts 131 of the connecting leads 13 proximate to the selected side surfaces 11cc of the substrate 11. As a result, it will cause damage to portions of the first finger parts 202 of the first mask 20 proximate to the selected side surface 11cc of the substrate 11, causing an etching length of the laser (along the second direction Y) to be greater than a distance between the first finger parts 202 of the first mask 20 and the selected side surface 11cc of the substrate 11. It can be understood that in this case, the dimension of the first sub-gap area 151 along the second direction Y is increased compared to the distance between the first finger parts 202 and the selected side surface 11cc along the second direction Y.

As shown in FIG. 40 and FIG. 41, a dimension of a first sub-gap area 151 of each first-type gap area 15 along the second direction Y is less than or equal to a dimension of a second sub-gap area 152 of the first-type gap area 15 along the second direction Y. During the manufacturing process of the display panel, the first finger part of the first mask has a relatively large dimension along the second direction, and the first finger part should extend as proximate to the selected side surface as possible, thereby more effectively blocking the laser from irradiating the driving circuit layer, and more portions of the conductive layer formed on the plurality of first finger parts do not need to be etched by the laser, further reducing the laser etching range and improving manufacturing efficiency.

In some embodiments, as shown in FIG. 40 and FIG. 41, a difference between the dimensions of the first sub-gap area 151 and the second sub-gap area 152 of each first-type gap area 15 along the first direction X is in a range of 0 to 100 µm.

The difference between the dimensions of the first sub-gap area 151 and the second sub-gap area 152 of each first-type gap area 15 along the first direction X is, for example, 0, 55 µm, or 100 µm.

A dimension of a first-type gap area 15 will affect a dimension of a connecting lead 13 immediately adjacent thereto. Therefore, on the basis of ensuring electrical insulation between two adjacent connecting leads 13, the dimensions of the first sub-gap area 151 and the second sub-gap area 152 of each first-type gap area 15 along the first direction X should not differ too much, so as to ensure the dimensional uniformity of the plurality of connecting leads 13, thereby ensuring the uniformity of their electrical performance.

In some embodiments, as shown in FIG. 41, first parts 131 of any two adjacent connecting leads 13 in the plurality of connecting leads 13 are spaced by a first-type gap area 15.

As shown in FIG. 41, first parts 131 of every two adjacent connecting leads 13 are spaced by a first-type gap area 15. That is to say, during the manufacturing process of the display panel, the first mask 20 includes, for example, as shown in FIG. 25, a plurality of first finger parts 202, and the plurality of first finger parts 202 are each located in a gap area between every adjacent two first bonding electrodes 12 in a one-to-one correspondence, so that the first parts 131 of the plurality of connecting leads 13 obtained are spaced by the first-type gap areas 15.

In some embodiments, as shown in FIG. 40, the first gaps J1 further include second-type gap areas 16, and a dimension p5 of a second-type gap area 16 along the first direction X is equal to a dimension p3 of a first sub-gap area 151 of a first-type gap area 15 along the first direction X.

As shown in FIG. 36, the second-type gap area 16 is obtained through etching a second-type etching area K13 in the conductive layer 13' by laser, and the first-type gap area 15 is obtained through etching a first sub-etching area K11 in the conductive layer by laser. Therefore, as shown in FIG. 40, the dimension of the second-type gap area 16 along the first direction X remains uniform and unchanged, and the dimension of the second-type gap area 16 along the first direction X is equal to the dimension of the first sub-gap area 151 of the first-type gap area 15 along the first direction X, which are both equal to the set etching width of the laser etching.

In some examples, as shown in FIG. 40, a first-type gap area 15 and at least one second-type gap area 16 are arranged alternately.

The arrangement method for the first-type gap areas 15 and the second-type gap areas 16 in the plurality of first gaps J1 is related to the arrangement method for the first finger parts of the first mask. The arrangement method is that a first-type gap area 15 and at least one second-type gap area 16 are arranged alternately, that is to say, every two adjacent first-type gap areas 15 are provided therebetween with at least one second-type gap area 16. As shown in FIG. 40, two adjacent first-type gap areas 15 are provided therebetween with one, two or more second-type gap areas 16.

In some embodiments, as shown in FIG. 40 and FIG. 41, in the plurality of first-type gap areas 15, a boundary line between a first sub-gap area 151 and a second sub-gap area 152 in each first-type gap area 15 is closer to the selected side surface 11cc of the substrate 11 than a boundary of ends of the plurality of first bonding electrodes 12 proximate to the selected side surface 11cc of the substrate 11.

As shown in FIG. 40 and FIG. 41, a distance p6 between the selected side surface 11cc and the boundary line between the first sub-gap area 151 and the second sub-gap area 152 is less than a distance L2 between the plurality of first bonding electrodes 12 and the selected side surface 11cc of the substrate 11. The boundary line between the first sub-gap area 151 and the second sub-gap area 152 is a boundary of an end of a first finger part 202 of the first mask 20 proximate to the selected side surface 11cc of the substrate 11, and the first finger part 202 of the first mask 20 exceeds the boundary of the ends of the plurality of first bonding electrodes 12 proximate to the selected side surface 11cc of the substrate 11. The first finger part 202 should extend as proximate to the selected side surface 11cc of the substrate 11 as possible, thereby further reducing the laser etching range and improving manufacturing efficiency.

In some embodiments, the plurality of first bonding electrodes 12 are arranged side by side at intervals along the first direction X. As shown in FIG. 40 and FIG. 41, a dimension p9 of a first bonding electrode 12 along the first direction X is less than or equal to a dimension p8/p8' of a first part 131 of a connecting lead 13 connected to the first bonding electrode 12 along the first direction X.

In order to ensure an effective connection of the first bonding electrode 12 of the connecting lead 13, the dimension of the first part 131 of the connecting lead along the first direction X is generally greater than or equal to the dimension of the first bonding electrode 12 connected thereto along the first direction X, so that the two have a larger contact area and can be connected more firmly.

It will be noted that since a first-type gap area 15 includes a first sub-gap area 151 and a second sub-gap area 152 with unequal dimensions, each of first parts 131 of connecting leads 13 spaced by the first-type gap area 15 is also divided into two parts with unequal dimensions, where a dimension of the first part 131 of the connecting lead 13 along the first direction X is an average value of dimensions of the two parts of the first part 131 of the connecting lead 13 along the first direction X.

In some embodiments, as shown in FIG. 40 and FIG. 41, a dimension of a first-type gap area 15 along the first direction X is less than or equal to a distance p10 between two first bonding electrodes 12 adjacent thereto along the first direction X.

As shown in FIG. 40 and FIG. 41, the dimension p3 of the first sub-gap area 151 of the first-type gap area 15 along the first direction X and the dimension p4 of the second sub-gap area 152 of the first-type gap area 15 along the first direction X are both less than or equal to the distance p10 between the two first bonding electrodes 12 adjacent to the first-type gap area 15 along the first direction X.

Corresponding to the manufacturing method for the display panel, the first mask includes a plurality of first finger parts, and a dimension of a first finger part along the first direction X is less than or equal to a distance p10 between two first bonding electrodes 12 adjacent thereto along the first direction X, an area corresponding to the first finger part forms a second sub-gap area 152, and the first sub-gap area 151 is determined by the laser etching width.

In some embodiments, as shown in FIG. 40 and FIG. 41, second parts 132 of two adjacent connecting leads 13 are spaced by a second gap J2. Each second gap J2 is obtained through etching a second etching area K2 of the conductive layer by laser. For example, the plurality of second gaps J2 have the same dimension along the first direction X.

For example, when forming the second parts 132 of the plurality of connecting leads 13, after the laser removes portions corresponding to the second etching areas K2 of the conductive layer 13' by etching, the laser with the residual energy will further remove portions corresponding to the first sub-etching areas K11 of the conductive layer 13'. It can be understood that the second gap J2 and the first sub-gap area 151 of the first gap J1 connected thereto are all etched by the same laser in the same step. Therefore, the second gap J2 and the first sub-gap area 151 of the first gap J1 connected thereto have the same dimension along the first direction X.

In some embodiments, as shown in FIG. 1A, the display panel 100 includes first bonding electrodes and a plurality of connecting leads, and no bonding electrode is provided on a side of the second surface of the substrate, so that portions of the third parts of the plurality of connecting leads away from the selected side surface are electrically connected to an integrated circuit chip or flexible circuit board to serve as bonding electrodes.

In some embodiments, as shown in FIG. 1B, FIG. 42, FIG. 43, and FIG. 44, the display panel 100 further includes: a plurality of second bonding electrodes 19. The plurality of second bonding electrodes 19 are disposed on a side of the second surface 11b of the substrate 11 and arranged at intervals along the first direction X. Each second bonding electrode 19 includes a first sub-part 191 and a second sub-part 192. The first sub-part 191 of each second bonding electrode 19 is closer to a selected side surface 11cc of the substrate 11 than the second sub-part 192 thereof. A third part 133 of each connecting lead 13 is electrically connected to a first sub-part 191 of a second bonding electrode 19. An extension direction of the first sub-part 191 of the second bonding electrode 19 is the same as an extension direction of a third part 133 of a connecting lead 13 electrically connected thereto.

The second bonding electrode 19 is non-linear, and the first sub-part 191 and the second sub-part 192 included in the second bonding electrode 19 have different extension directions.

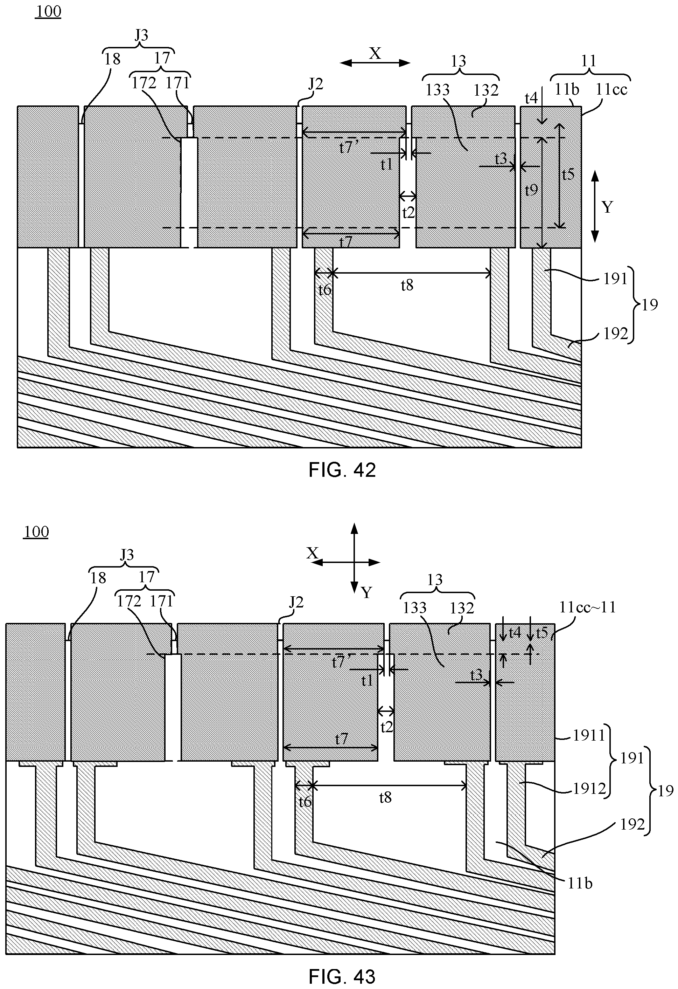

As shown in FIG. 42, FIG. 43 and FIG. 44, third parts 133 of two adjacent connecting leads 13 are spaced by a third gap J3. The third gaps J3 include third-type gap areas 17, and each third-type gap area 17 in the plurality of third-type gap areas 17 includes a third sub-gap area 171 and a fourth sub-gap area 172, where the third sub-gap area 171 of each third-type gap area 17 is closer to the selected side surface 11cc of the substrate 11 than the fourth sub-gap area 172 of the third-type gap area 17. A dimension t1 of the third sub-gap area 171 of each third-type gap area 17 along the first direction X is less than a dimension t2 of the fourth sub-gap area 172 of the third-type gap area 17 along the first direction X.

Referring to the foregoing description of the manufacturing method for the display panel, the laser Laser2 etches the second portion of the conductive layer to form the second parts of the plurality of connecting leads. Since portions of the second sub-parts of the plurality of second bonding electrodes proximate to the selected side surface of the substrate are covered by the second main body part of the second mask, after the laser removes portions corresponding to the third etching areas K3 by etching, the laser is blocked by the second main body part of the second mask, thereby avoiding the problem that the second sub-parts 192 of the second bonding electrodes 19 are damaged by the residual energy of the laser. Moreover, the second mask further includes second finger parts, and portions of the conductive layer formed on the plurality of second finger parts can be removed together with the removal of the second mask, so that the fourth sub-gap areas 172 of the third gaps can be formed without the need for etching portions of the conductive layer (the fourth sub-etching areas K32) by laser, and the dimension of the fourth sub-gap area 172 is consistent with the dimension of the second finger part, thereby saving the laser etching step, reducing the laser etching range and improving manufacturing efficiency. The third parts of the plurality of connecting leads finally obtained have structural features corresponding to the second mask, adjacent third parts are spaced by a third gap, and the dimension of the third sub-gap area 171 of each third-type gap area 17 along the first direction X is less than the dimension of the fourth sub-gap area 172 of the third-type gap area 17 along the first direction X.

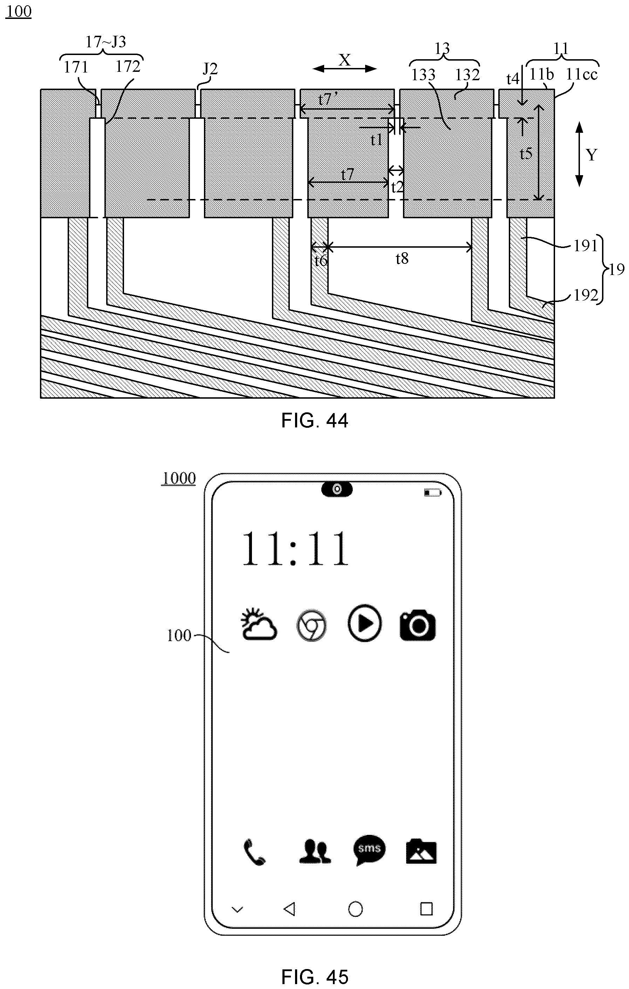

In some embodiments, as shown in FIG. 44, third parts 133 of any two adjacent connecting leads 13 in the plurality of connecting leads 13 are spaced by a third-type gap area 17.

The third parts 133 of every two adjacent connecting leads 13 in the plurality of connecting leads 13 are spaced by a third-type gap area 17, corresponding to the second mask 21 in FIG. 33. The second mask 21 includes the plurality of second finger parts, and the plurality of second finger parts are each in one-to-one correspondence with the gap between every two adjacent second bonding electrodes, so as to enable the obtained plurality of connecting leads 13 to have the above features.

In some embodiments, as shown in FIG. 42 and FIG. 43, the third gaps J3 further include fourth-type gap areas 18, and a third-type gap area 17 and at least one fourth-type gap area 18 are alternately arranged. A dimension t3 of the fourth-type gap area 18 along the first direction X is equal to a dimension t1 of the third sub-gap area 171 of the third-type gap area 17 along the first direction X.

As shown in FIG. 28, the fourth-type gap area 18 is obtained through etching a fourth-type etching area K33 of the conductive layer 13' by laser, and the third-type gap area 17 is obtained through etching a third sub-etching area K31 and a fourth sub-etching area K32 in the conductive layer by laser. Therefore, as shown in FIG. 42 and FIG. 43, the dimension of the fourth-type gap area 18 along the first direction X is uniform and unchanged, and the dimension t3 of the fourth-type gap area 18 along the first direction X is equal to the dimension of the first sub-gap area 151 of the first-type gap area 15 along the first direction X, which are both equal to the set etching width of the laser etching.

In some embodiments, as shown in FIG. 42, FIG. 43, and FIG. 44, in the plurality of third-type gap areas 17, a boundary line between the third sub-gap area 171 and the fourth sub-gap area 172 in each third-type gap area 17 is closer to the selected side surface 11cc than a boundary of ends of the plurality of second bonding electrodes 19 proximate to the selected side surface 11cc of the substrate 11.

As shown in FIG. 42, FIG. 43, and FIG. 44, a distance t4 between the boundary line between the third sub-gap area 171 and the fourth sub-gap area 172 and the selected side surface 11cc of the substrate 11 is less than a distance t5 between the plurality of second bonding electrodes 19 and the selected side surface.

Further, as shown in FIG. 42, a distance t9 between the boundary line between the third sub-gap area 171 and the fourth sub-gap area 172 and a boundary of a side of the third part 133 of the connecting lead 13 away from the selected side surface 11cc of the substrate 11 is greater than the distance t4 between the selected side surface 11cc and the boundary line between the third sub-gap area 171 and the fourth sub-gap area 172.

With such a design, the dimension of the first sub-gap area 151 included in the first-type gap area 15 along the second direction Y is less than the dimension of the second sub-gap area 152 included in the first-type gap area 15 along the second direction Y. The second sub-gap area 152 included in the first-type gap area 15 is formed, for example, with the removal of the second finger part 212 when the second mask 21 is removed. The first sub-gap area 151 included in the first-type gap area 15 is formed by, for example, laser etching. It can be understood that adopting such a design reduces the range of laser etching and further improves the manufacturing efficiency of the connecting leads 13.

For example, as shown in FIG. 43, the first sub-part 191 of the second bonding electrode 19 includes a first connecting sub-part 1911 and a second connecting sub-part 1912, where the first connecting sub-part 1911 of each first sub-part 191 is closer to the selected side surface 11cc of the substrate 11 than the second connecting sub-part 1912 of the first sub-part 191. The distance t4 between the selected side surface 11cc of the substrate 11 and the boundary line between the third sub-gap area 171 and the fourth sub-gap area 172 is greater than the distance t5 between the plurality of second bonding electrodes 19 and the selected side surface.

A second connecting sub-part 1912 of a first sub-part 191 of each second bonding electrode 19 is configured to be electrically connected to a second sub-part 192 of the second bonding electrode 19. A first connecting sub-part 1911 of the first sub-part 191 of the second bonding electrode 19 is configured to be electrically connected to a third part 133 of a connecting lead 13.

Referring to FIG. 43, in a case where the second bonding electrode 19 is non-linear, an extension direction of a portion of the second bonding electrode 19 proximate to the selected side surface 11cc of the substrate 11 is perpendicular to the selected side surface 11cc of the substrate 11, and an extension direction of a portion of the second bonding electrode 19 away from the selected side surface 11cc of the substrate 11 forms a certain angle with a plane where the selected side surface 11cc of the substrate 11 is located.

It can be understood that if the second bonding electrode 19 has a fixed width, for example, the dimension of the second connecting sub-part 1912 included in the first sub-part 191 of the second bonding electrode in a direction perpendicular to its extension direction is the same as the dimension of the first connecting sub-part 1911 included in the first sub-part 191 in the direction perpendicular to its extension direction, then there is a risk of short circuit caused by the contact between second connecting sub-parts 1912 of first sub-parts 191 of two adjacent second bonding electrodes 19.

Therefore, a design is adopted in which the dimension of the second connecting sub-part 1912 of the first sub-part 191 in a direction perpendicular to its extension direction is less than the dimension of the first connecting sub-part 1911 of the first sub-part 191 in a direction perpendicular to its extension direction, and the second connecting sub-part 1912 of each first sub-part 191 is used as a transition connecting part, thereby ensuring that the plurality of second bonding electrodes 19 can be independently separated from each other without causing any two second bonding electrodes 19 in the plurality of second bonding electrodes 19 to be connected and cause a short circuit, while increasing an overlapping area of the second bonding electrode 19 and the connecting lead 13.

Further, a dimension of a first connecting sub-part 1911 included in a first sub-part 191 of each second bonding electrode 19 along the first direction X is greater than a dimension of a second connecting sub-part 1912 included in the first sub-part 191 along the first direction X. The second connecting sub-part 1912 overlaps with a third part 133 of a connecting lead 13 electrically connected thereto. It can be understood that with such a design, an area of overlapping portions of the second bonding electrode 19 and the connecting lead 13 electrically connected thereto is increased, thereby ensuring that the second bonding electrode 19 and the connecting lead 13 electrically connected thereto can be in a sufficient contact, and ensuring the connection stability between the second bonding electrode 19 and the connecting lead 13.

Moreover, since an area of the portion of the second bonding electrode 19 connected to the connecting lead is increased, correspondingly, the impedance of this portion will also be reduced under other conditions (such as the dimension of the second bonding electrode 19 in the direction perpendicular to the substrate 11 and the dimension of the overlapping portions of the second bonding electrode 19 and the connecting lead 13 along the second direction Y) remaining unchanged, making the signal transmission between the second bonding electrode 19 and the connecting lead 13 more stable.

For example, as shown in FIG. 43, a second connecting sub-part 1912 of a first sub-part 191 of a second bonding electrode 19 and a second sub-part 192 of the second bonding electrode 19 have the same or substantially the same width. The width of the second connecting sub-part 1912 and the second sub-part 192 mentioned here refers to a dimension of the second connecting sub-part 1912/second sub-part 192 in a direction perpendicular to its extension direction.

In some embodiments, as shown in FIG. 42, FIG. 43, and FIG. 44, the plurality of second bonding electrodes 19 are arranged at intervals along the first direction X. A dimension t6 of a first sub-part 191 of a second bonding electrode 19 along the first direction X is less than or equal to a dimension t7 of a third part 133 of a connecting lead 13 connected to the second bonding electrode 19 along the first direction X.

In some embodiments, as shown in FIG. 42, FIG. 43, and FIG. 44, a dimension of a third-type gap area 17 along the first direction X is less than or equal to a distance t8 between first sub-parts 191 of two second bonding electrodes 19 adjacent thereto along the first direction X.

The dimension t1 of the third sub-gap area 171 of the third-type gap area 17 along the first direction X and the dimension t2 of the fourth sub-gap area 172 of the third-type gap area 17 along the first direction X are both less than or equal to the distance t8 between the first sub-parts 191 of the two second bonding electrodes 19 adjacent thereto along the first direction X.

Further, as shown in FIG. 38 and FIG. 39, the display panel 100 further includes a light-emitting device layer G. The light-emitting device layer G includes a plurality of light-emitting devices G1 and a protective film G3.

For example, the display panel 100 includes sub-pixels P of at least three colors, where the sub-pixels of the multiple colors include at least sub-pixels of a first color, sub-pixels of a second color and sub-pixels of a third color, and the first color, the second color and the third color are three primary colors (e.g., red, green and blue). For example, each sub-pixel P includes at least one light-emitting device G1.

In some examples, as shown in FIG. 38 and FIG. 39, the protective film G3 includes a portion covering the plurality of light-emitting devices G1 and a portion filling gap areas of the plurality of light-emitting devices G1. For example, a material of the protective film G3 may be black silicone or black resin. The protective film G3 can protect the plurality of light-emitting devices G1, preventing the plurality of light-emitting devices G1 from being damaged during the process after forming the light-emitting devices G1.

For example, the light-emitting device G1 includes, but is not limited to, an organic light-emitting diode (OLED), a mini light-emitting diode (Mini LED), or a micro light-emitting diode (Micro LED).

In yet another aspect, a display device 1000 is provided, as shown in FIG. 45, which includes the display panel 100 described in any one of the above embodiments.

The mini light-emitting diode or micro light-emitting diode, which serves as the light-emitting device G1, occupies a smaller volume and has smaller particles compared to traditional LEDs, making a light source density per unit area higher and a unit size of the light source smaller within the same screen size. Therefore, more precise local control of the light-emitting device G1 can be achieved without causing an uneven brightness of the light-emitting device G1, ensuring the uniformity of the display brightness and thus ensuring the display quality of the display device 1000.

In some embodiments, the display device 1000 further includes an integrated circuit chip and a flexible circuit board F.

For example, the integrated circuit chip is configured to be electrically connected to the flexible circuit board F, control signals are output through the integrated circuit chip, and then driving signals are transmitted to the plurality of connecting leads 13 through the flexible circuit board F, and transmitted to the plurality of first bonding electrodes 12 through the plurality of connecting leads 13. The plurality of first bonding electrodes 12 are configured to achieve an electrical connection with the driving circuit layer 14.

The driving circuit layer 14 includes structures such as a plurality of signal lines. The driving circuit layer 14 is coupled to the light-emitting device layer G and is configured to drive the light-emitting device layer G to emit light. Specifically, the first bonding electrodes 12 receive the driving signals transmitted by the plurality of connecting leads 13 and transmit the driving signals to the driving circuit layer 14, thereby controlling the light-emitting device layer G to emit light to enable the display device 1000 to display an image.

For example, as shown in FIG. 38 and FIG. 39, the light-emitting device layer G further includes pixel driving chips G2. It can be understood that the driving circuit layer 14 may further be connected to the pixel driving chips G2, so that the pixel driving chips G2 control the brightness of the light-emitting devices G1. Specifically, three light-emitting devices G1 may be driven and controlled by one pixel driving chip G2, which is not limited and is only used as an example of a possible implementation.

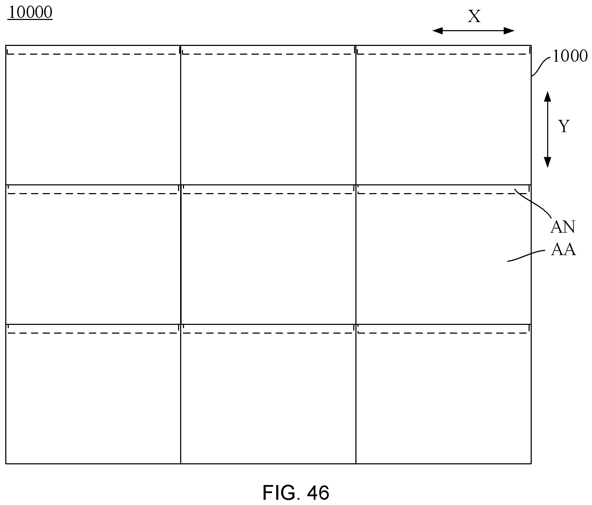

In yet another aspect, a tiled display device 10000 is provided, as shown in FIG. 46, which includes: a plurality of display device 1000 each as described in any one of the above embodiments.

For example, the plurality of display device 1000 in the tiled display device 10000 are arranged in an array.

For example, as shown in FIG. 46, the display device 1000 is in a shape of, for example, a rectangle.

In the display panel 100, a plurality of first bonding electrodes 12 are arranged side by side along a first direction X, and accordingly, a plurality of connecting leads 13 are also arranged side by side along the first direction X. Another direction, which is parallel to a display surface of the display device 1000 and perpendicular to the first direction X, is called a second direction Y. The display device 1000 includes a plurality of side surfaces. In the following description, a side surface proximate to a peripheral area AN of a substrate 11 in the plurality of side surfaces of the display device 1000 refers to a selected side surface of the display device 1000.

For example, as shown in FIG. 40 and FIG. 41, the display panel 100 includes a display area AA and a peripheral area AN located on a side of the display area AA. The plurality of connecting leads 13 and the plurality of first bonding electrodes 12 are provided proximate to the peripheral area AN of the substrate 11.

Further, as shown in FIG. 46, in a case where the plurality of display devices 1000 each including a display panel 100 as shown in FIG. 46 are spliced, selected side surfaces of two adjacent display devices 1000 are arranged along the first direction X. In this way, in multiple display devices 1000 arranged in a row along the first direction X, there is basically no splicing seam between two adjacent display devices 1000 along the first direction X; and in multiple display devices 1000 arranged in a column along the second direction Y, there is a splicing seam between two adjacent display devices 1000.

That is to say, in the multiple display devices 1000 arranged in a row along the first direction X, a dimension of the splicing seam between two adjacent display devices is less than a dimension of the splicing seam between two adjacent display devices 1000 in the multiple display devices 1000 arranged in a column along the second direction Y. Since a dimension of the peripheral area AN in the second direction Y is very small, when the tiled display device 10000 is actually viewed, the splicing seam between two adjacent display devices 1000 is difficult to detect with the naked eye within the viewing distance, thus making the display image of the tiled display device 10000 relatively complete and presenting a better display effect.

The foregoing descriptions are merely specific embodiments of the present disclosure, but the protection scope of the present disclosure is not limited thereto. Changes or replacements that any person skilled in the art could conceive of within the technical scope of the present disclosure shall be included in the protection scope of the present disclosure. Therefore, the protection scope of the present disclosure shall be subject to the protection scope of the claims.

## Claims

1. A display panel, comprising:
a substrate, wherein the substrate includes a first surface, a second surface, and a plurality of side surfaces connecting the first surface and the second surface, and at least one side surface of the plurality of side surfaces is a selected side surface; and the first surface includes a display area and a peripheral area located on at least one side of the display area, and the peripheral area is closer to the selected side surface than the display area;
a driving circuit layer provided in the display area;
a plurality of first bonding electrodes provided in the peripheral area, wherein the plurality of first bonding electrodes are arranged at intervals along a first direction, and the first direction is parallel to the selected side surface and the first surface; and
a plurality of connecting leads arranged at intervals along the first direction, wherein each connecting lead of the plurality of connecting leads includes a first part located on a side of the first surface, a second part located on a side of the selected side surface, and a third part located on a side of the second surface; the first part of each connecting lead is electrically connected to one of the first bonding electrodes;
wherein first parts of two adjacent connecting leads are spaced by a first gap, first gaps include first-type gap areas, a first-type gap area includes a first sub-gap area and a second sub-gap area, and the first sub-gap area is closer to the selected side surface than the second sub-gap area; and a dimension of the first sub-gap area along the first direction is less than a dimension of the second sub-gap area along the first direction.

2. The display panel according to claim 1, wherein a dimension of the first sub-gap area along a second direction is less than or equal to a dimension of the second sub-gap area along the second direction; and
the second direction is parallel to an extension direction of the first part of the connecting lead.

3. The display panel according to claim 1 or 2, wherein a difference between dimensions of a first sub-gap area and a second sub-gap area of each first-type gap area along the first direction is in a range of 0 to 100 µm.

4. The display panel according to any one of claims 1 to 3, wherein first parts of any two adjacent connecting leads of the plurality of connecting leads are spaced by a first-type gap area.

5. The display panel according to any one of claims 1 to 3, wherein the first gaps further include second-type gap areas, and a dimension of a second-type gap area along the first direction is equal to the dimension of the first sub-gap area along the first direction.

6. The display panel according to claim 5, wherein a first-type gap area and at least one second-type gap area are arranged alternately.

7. The display panel according to any one of claims 1 to 6, wherein in a plurality of first-type gap areas, a boundary line between a first sub-gap area and a second sub-gap area of each first-type gap area is closer to the selected side surface than a boundary of ends, proximate to the selected side surface, of the plurality of first bonding electrodes.

8. The display panel according to any one of claims 1 to 7, wherein the plurality of first bonding electrodes are arranged side by side at intervals along the first direction; and
a dimension of a first bonding electrode along the first direction is less than or equal to a dimension of a first part of a connecting lead connected to the first bonding electrode along the first direction.

9. The display panel according to any one of claims 1 to 8, wherein a dimension of the first-type gap area along the first direction is less than or equal to a distance between two first bonding electrodes adjacent thereto along the first direction.

10. The display panel according to any one of claims 1 to 9, wherein the display panel further comprises:
a plurality of second bonding electrodes provided on the side of the second surface, wherein the plurality of second bonding electrodes are arranged at intervals along the first direction; and each second bonding electrode includes a first sub-part and a second sub-part, and the first sub-part is closer to the selected side surface than the second sub-part;
the third part of each connecting lead is electrically connected to a first sub-part, and an extension direction of the first sub-part is the same as an extension direction of the third part of the connecting lead electrically connected thereto; and
third parts of two adjacent connecting leads are spaced by a third gap, third gaps include third-type gap areas, and each third-type gap area in a plurality of third-type gap areas includes a third sub-gap area and a fourth sub-gap area, and the third sub-gap area is closer to the selected side surface than the fourth sub-gap area;
wherein a dimension of the third sub-gap area along the first direction is less than a dimension of the fourth sub-gap area along the first direction.

11. The display panel according to claim 10, wherein third parts of any two adjacent connecting leads of the plurality of connecting leads are spaced by a third-type gap area.

12. The display panel according to claim 10, wherein the third gaps further include fourth-type gap areas, and a dimension of a fourth-type gap area along the first direction is equal to the dimension of the third sub-gap area along the first direction; and
a third-type gap area and at least one fourth-type gap area are arranged alternately.

13. The display panel according to any one of claims 10 to 12, wherein in a plurality of third-type gap areas, a boundary line between a third sub-gap area and a fourth sub-gap area of each third-type gap area is closer to the selected side surface than a boundary of ends, proximate to the selected side surface, of the plurality of second bonding electrodes.

14. The display panel according to any one of claims 10 to 13, wherein the plurality of second bonding electrodes are arranged at intervals along the first direction; and
a dimension of a first sub-part of a second bonding electrode along the first direction is less than or equal to a dimension of a third part of a connecting lead connected to the second bonding electrode along the first direction.

15. The display panel according to any one of claims 10 to 14, wherein a dimension of the third-type gap area along the first direction is less than or equal to a distance between first sub-parts of two second bonding electrodes adjacent thereto along the first direction.

16. A display device, comprising the display panel according to any one of claims 1 to 15.

17. A tiled display device, comprising a plurality of display devices each according to claim 16.

18. A manufacturing method for a display panel, comprising:
providing a substrate, wherein the substrate includes a first surface, a second surface, and a plurality of side surfaces connecting the first surface and the second surface, and at least one side surface of the plurality of side surfaces is a selected side surface; and the first surface includes a display area and a peripheral area located on at least one side of the display area, and the peripheral area is closer to the selected side surface than the display area;
forming an array layer on a side of the first surface, wherein forming the array layer on the side of the first surface includes: forming a driving circuit layer in the display area;
providing a first mask on the side of the first surface, wherein the first mask includes at least a first main body part, and the first main body part covers at least a portion of the driving circuit layer proximate to the selected side surface;
forming a conductive layer, wherein the conductive layer includes: a first portion located on the side of the first surface, a second portion located on a side of the selected side surface, and a third portion located on a side of the second surface;
patterning the conductive layer by laser etching to form a plurality of connecting leads arranged side by side at intervals, wherein each connecting lead of the plurality of connecting leads includes a first part located on the side of the first surface, a second part located on the side of the selected side surface, and a third part located on the side of the second surface; and etching the conductive layer by the laser to form the plurality of connecting leads includes: etching at least the second portion of the conductive layer by the laser to form second parts of the plurality of connecting leads; and
removing the first mask.

19. The manufacturing method according to claim 18, wherein forming the array layer on the side of the first surface further includes: forming a plurality of first bonding electrodes in the peripheral area, wherein the plurality of first bonding electrodes are arranged at intervals along a first direction, and each first bonding electrode extends along a second direction; and the peripheral area extends along the first direction, and the first direction intersects the second direction; and
in a step of providing the first mask on the side of the first surface, the first main body part of the first mask further covers portions of the plurality of first bonding electrodes proximate to the display area.

20. The manufacturing method according to claim 19, wherein in a step of providing the first mask on one side of the first surface, the first mask further includes a plurality of first finger parts; first ends of the plurality of first finger parts are connected to the first main body part, and second ends of the plurality of first finger parts extend toward the selected side surface; the plurality of first finger parts are closer to the selected side surface than the first main body part; and each first finger part is located in a gap area between two adjacent first bonding electrodes.
